# EUROPEAN PATENT APPLICATION

(11) **EP 3 705 600 A1**
(43) Date of publication of application: **09.09.2020**
(21) Application number: 18872879.4
(22) Date of filing: 15.10.2018
(51) Int. Cl.: C23C 14/04, H01L 51/50, H05B 33/10

(54) **VAPOR DEPOSITION MASK DEVICE**

(30) Priority: 01.11.2017 JP 2017212018
(71) Applicant: Dainippon Printing Co., Ltd., Shinjuku-ku Tokyo 162-8001 (JP)
(72) Inventor: OKAMOTO Hideyuki, Tokyo 162-8001 (JP)
(74) Representative: Müller-Boré & Partner Patentanwälte PartG mbB
(86) International application number: PCT/JP2018/038261
(87) International publication number: WO 2019/087749

(57) **Abstract**

A deposition mask apparatus includes: a deposition mask having a plurality of mask through-holes extending from a first surface which is positioned closer to the substrate, to reach a second surface which is positioned opposite to the first surface; and a frame provided with an opening which is overlapped with a part of the deposition mask, the frame supporting the deposition mask.

## Description

### Technical Field

An embodiment of the present disclosure relates to a deposition mask device comprising a deposition mask having a plurality of through-holes formed therein, a frame that supports the deposition mask.

### Background Art

A display device used in a portable device such as a smart phone and a tablet PC is required to have high fineness, e.g., a pixel density of 400 ppi or more. In addition, there is increasing demand that the portable device is applicable to ultra-high definition (UHD). In this case, the pixel density of a display device is preferably 800 ppi or more.

Among display devices, an organic EL display device draws attention because of its excellent responsibility, low power consumption, and high contrast. A known method for forming pixels of an organic EL display device is a method which uses a deposition mask in which through-holes are formed and arranged in a desired pattern, and forms pixels in the desired pattern. To be specific, a deposition mask is firstly brought into tight contact with a substrate for an organic EL display device, and then the substrate and the deposition mask in tight contact therewith are put into a deposition apparatus so as to conduct a deposition step of depositing an organic material on the substrate. In this case, in order to precisely manufacture a an organic EL display device having a high pixel density, positions and shapes of the through-holes in the deposition mask are required to be precisely recreated in accordance with a design.

A deposition apparatus that deposits a deposition material such as an organic material onto a substrate comprises a deposition mask apparatus including a deposition mask and a frame that supports the deposition mask. The frame supports the deposition mask in a taut state so that the deposition mask is not bent. The deposition mask is fixed onto the frame by welding, adhering, plating, soldering or crimping. A substrate is placed in such a deposition mask apparatus, and a deposition step is performed.

Patent Document 1: JP5382259B
Patent Document 2: JP2001-234385A

When a substrate is placed in a deposition mask apparatus, there is a possibility that a holding member holding the substrate and a frame interfere with each other. In this case, it is difficult to place the substrate at a desired position, so that a deposition material may not be deposited at a desired position on the substrate.

The object of the disclosure is to provide a deposition mask apparatus that can effectively solve such a problem.

### Disclosure Of The Invention

One embodiment of the present disclosure is a deposition mask apparatus to be at least temporarily combined with a substrate held by a holding member, the deposition mask apparatus comprising: a deposition mask having a plurality of mask through-holes extending from a first surface which is positioned closer to the substrate, to reach a second surface which is positioned opposite to the first surface; and a frame provided with an opening which is overlapped with a part of the deposition mask, the frame supporting the deposition mask; wherein: the frame has a front surface facing the second surface of the deposition mask, a rear surface opposed to the front surface, an outside surface spreading between the front surface and the rear surface, and an inside surface spreading inside the outside surface between the front surface and the rear surface to face the opening; and a plurality of accommodation parts capable of accommodating at least a part of the holding member are formed in the front surface of the frame at positions apart from the opening.

In the deposition mask apparatus of the embodiment of this disclosure, the plurality of accommodation parts may be formed between the opening and the outside surface.

In the deposition mask apparatus of the embodiment of this disclosure, the plurality of accommodation parts may be formed between the opening and the outside surface.

In the deposition mask apparatus of the embodiment of this disclosure, the plurality of accommodation parts may extend to reach the outside surface.

In the deposition mask apparatus of the embodiment of this disclosure, the front surface of the frame may include a first front surface positioned closer to the inside surface, and a second front surface positioned closer to the outside surface and positioned closer to the rear surface than the first front surface ; the first front surface and the second front surface may be connected to each other through an intermediate surface; and the accommodation parts may be formed in the first front surface to extend to reach the intermediate surface.

In the deposition mask apparatus of the embodiment of this disclosure, the plurality of accommodation parts may be formed to surround the opening.

In the deposition mask apparatus of the embodiment of this disclosure, the deposition mask may include a joint portion welded to the front surface of the frame; and at least a part of the joint portion may be positioned between the opening and the accommodation parts.

In the deposition mask apparatus of the embodiment of this disclosure, at least some of the respective accommodation parts may be formed inside a pair of ends in a longitudinal direction of the deposition mask.

One embodiment of the present disclosure is a deposition mask apparatus comprising: a deposition mask having a first surface, and a second surface positioned opposite to the first surface; and a frame having a third surface positioned closer to the deposition mask, and a fourth surface positioned opposite to the third surface; wherein: the deposition mask and the frame are joined to each other through a joint portion; the frame further has a fifth surface positioned outside the joint portion; and at least a part of the fifth surface is positioned closer to the fourth surface than the third surface.

The present disclosure enables that a substrate is placed at desired position, and that a deposition material is deposited at a desired position on the substrate.

### Brief Description Of The Drawings

Fig. 1A is a view showing a deposition apparatus comprising a deposition mask apparatus according to one embodiment of the present disclosure.
Fig. 1B is a sectional view showing an organic EL display device manufactured with the use of the deposition mask apparatus shown in Fig. 1A.
Fig. 2A is a plan view showing the deposition mask apparatus according to the one embodiment of the present disclosure.
Fig. 2B is a plan view showing a frame of the deposition mask apparatus according to the one embodiment of the present disclosure.
Fig. 3 is a plan view showing in enlargement an accommodation part of the frame of the deposition mask apparatus shown in Fig. 2A.
Fig. 4A is a plan view showing a modification example of a joint portion formed on an ear portion of the deposition mask.
Fig. 4B is a plan view showing a modification example of a joint portion formed on an ear portion of the deposition mask.
Fig. 4C is a plan view showing a modification example of a joint portion formed on an ear portion of the deposition mask.
Fig. 4D is a plan view showing a modification example of a joint portion formed on an ear portion of the deposition mask.
Fig. 4E is a plan view showing a modification example of a joint portion formed on an ear portion of the deposition mask.
Fig. 5A is a sectional view of the deposition mask apparatus seen from the VA-VA direction.
Fig. 5B is a sectional view showing in enlargement the deposition mask apparatus shown in Fig. 5A (a sectional view corresponding to the VB part of Fig. 5A).
Fig. 5C is a sectional view showing in enlargement a welding taint shown in Fig. 5B (a sectional view corresponding to the VC part of Fig. 5B).
Fig. 5D is a sectional view showing a modification example of the welding taint.
Fig. 5E is a sectional view showing a modification example of the welding taint.
Fig. 6 is a plan view showing in enlargement an intermediate portion of the deposition mask.
Fig. 7 is a sectional view of the intermediate portion of Fig. 6 seen from the VII-VII direction.
Fig. 8 is a view showing a step of forming a resist pattern on a metal plate.
Fig. 9 is a view showing a first surface etching step.
Fig. 10 is a view showing a second surface etching step.
Fig. 11 is a view showing a step of removing a resin and the resist pattern from the metal plate.
Fig. 12A is a step of manufacturing a frame.
Fig. 12B is a step of manufacturing the frame.
Fig. 13A is a view showing a step of depositing a deposition material onto an organic EL substrate.
Fig. 13B is a view showing a step of depositing the deposition material onto the organic EL substrate.
Fig. 14A is a view showing a step of depositing the deposition material onto the organic EL substrate.
Fig. 14B is a view showing a step of depositing the deposition material onto the organic EL substrate.
Fig. 15 is a sectional view showing a modification example of the ear portion of the deposition mask.
Fig. 16 is a plan view showing a modification example of a deposition mask apparatus.
Fig. 17A is a plan view showing a modification example of the deposition mask apparatus.
Fig. 17B is a sectional view showing a step of installing the organic EL substrate on the frame, in a modification example of the deposition mask apparatus.
Fig. 17C is a plan view showing a modification example of the deposition mask apparatus.
Fig. 18 is a plan view showing a modification example of the deposition mask apparatus.
Fig. 19 is a plan view showing a modification example of the deposition mask apparatus.
Fig. 20 is a plan view showing a modification example of the deposition mask apparatus, which corresponds to a sectional view seen from the VA-VA direction of Fig. 3.
Fig. 21 is a plan view showing a modification example of the deposition mask apparatus.
Fig. 22 is a plan view showing a modification example of the deposition mask apparatus, which corresponds to a sectional view seen from the XXII-XXII direction of Fig. 21.
Fig. 23A is a plan view showing a modification example of the deposition mask apparatus, which corresponds to a sectional view seen from the VA-VA direction of Fig. 3.
Fig. 23B is a plan view showing a modification example of the deposition mask apparatus, which corresponds to a sectional view seen from the VA-VA direction of Fig. 3.
Fig. 23C is a plan view showing a modification example of the deposition mask apparatus, which corresponds to a sectional view seen from the VA-VA direction of Fig. 3.
Fig. 23D is a plan view showing a modification example of the deposition mask apparatus, which corresponds to a sectional view seen from the VA-VA direction of Fig. 3.
Fig. 23E is a plan view showing a modification example of the deposition mask apparatus, which corresponds to a sectional view seen from the VA-VA direction of Fig. 3.
Fig. 23F is a plan view showing a modification example of the deposition mask apparatus, which corresponds to a sectional view seen from the VA-VA direction of Fig. 3.
Fig. 23G is a plan view showing a modification example of the deposition mask apparatus, which corresponds to a sectional view seen from the VA-VA direction of Fig. 3.
Fig. 23H is a plan view showing a modification example of the deposition mask apparatus, which corresponds to a sectional view seen from the VA-VA direction of Fig. 3.
Fig. 23I is a plan view showing a modification example of the deposition mask apparatus, which corresponds to a sectional view seen from the VA-VA direction of Fig. 3.
Fig. 23J is a plan view showing a modification example of the deposition mask apparatus, which corresponds to a sectional view seen from the VA-VA direction of Fig. 3.
Fig. 23K is a plan view showing a modification example of the deposition mask apparatus, which corresponds to a sectional view seen from the VA-VA direction of Fig. 3.
Fig. 23L is a plan view showing a modification example of the deposition mask apparatus, which corresponds to a sectional view seen from the VA-VA direction of Fig. 3.
Fig. 24 is a plan view showing a modification example of the deposition mask apparatus.
Fig. 25A is a sectional view showing a modification example of a holding member, which corresponds to a sectional view seen from the VA-VA direction of Fig. 3.
Fig. 25B is a sectional view showing a modification example of the holding member, which corresponds to a sectional view seen from the VA-VA direction of Fig. 3.

### Mode for Carrying out the Invention

Herebelow, an embodiment of the present disclosure is described with reference to the drawings. In the drawings attached to the specification, a scale dimension, an aspect ratio and so on are changed and exaggerated from the actual ones, for the convenience of easiness in illustration and understanding.

The below-described embodiments are examples of the embodiment of the present disclosure, and the present disclosure should not be limited to these embodiments. In addition, the below embodiments and modification examples can be suitably combined. In addition, it is possible to combine a plurality of embodiments, to combine a plurality of modification examples, and to combine a plurality of embodiments and a plurality of modification examples.

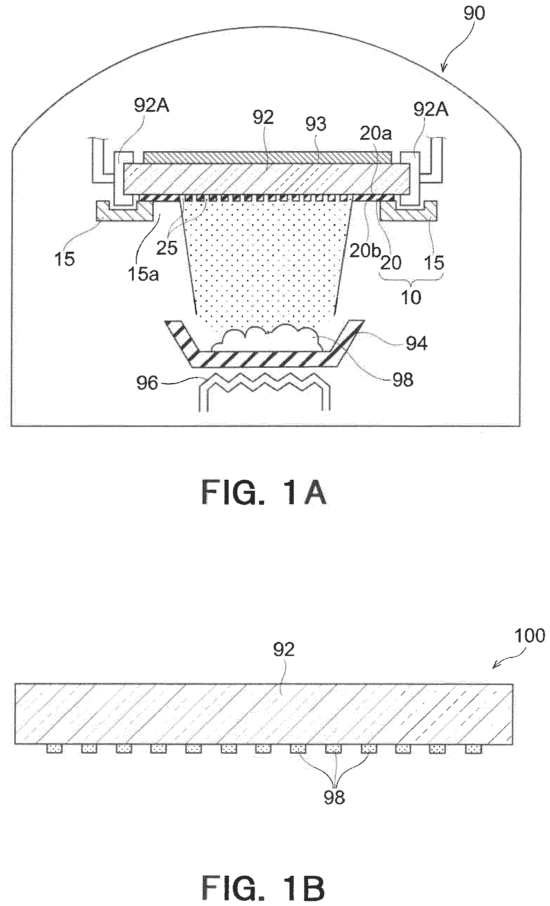

Figs. 1A to 14B are views for describing an embodiment of the present disclosure. In the below embodiment and the modification example, a manufacturing method of a deposition mask, which is used for patterning an organic material on a substrate in a desired pattern when an organic EL display device is manufactured, is described by way of example. However, not limited thereto, the present disclosure can be applied to a manufacturing method for a deposition mask for various uses. For example, a deposition mask apparatus 10 may be used when a transparent electrode for color filter is formed.

In this specification, terms "plate", "sheet" and "film" are not differentiated from one another based only on the difference of terms. For example, the "plate" is a concept including a member that can be referred to as sheet or film.

In addition, the term "plate plane (sheet plane, film plane)" means a plane corresponding to a plane direction of a plate-like (sheet-like, film-like) member as a target, when the plate-like (sheet-like, film-like) member as a target is seen as a whole in general. A normal direction used to the plate-like (sheet-like, film-like) member means a normal direction with respect to a plate plane (sheet surface, film surface) of the member.

Further, in this specification, terms specifying shapes, geometric conditions and their degrees, e.g., "parallel", "orthogonal", "same", "similar" etc., and values of a length, an angle and a physical property are not limited to their strict definitions, but construed to include a range capable of exerting a similar function.

### (Deposition Apparatus)

Firstly, a deposition apparatus 90 that performs a deposition process in which a deposition material is deposited on an object is described with reference to Fig. 1A. As shown in Fig. 1A, the deposition apparatus 90 comprises therein a deposition source (e.g., crucible 94), a heater 96, and a deposition mask apparatus 10. The crucible 94 accommodates a deposition material 98 such as an organic luminescent material. The heater 96 heats the crucible 94 so as to evaporate the deposition material 98. The deposition mask apparatus 10 is disposed to be opposed to the crucible 94. In addition, a substrate, which is an object onto which the deposition material 98 is deposited, e.g., an organic EL substrate 92 is placed on the deposition mask apparatus 10 b a holding member 92A that holds the organic EL substrate 92. Herein, the holding member 92A may be a clamp that clamps the organic EL substrate 92.

### (Deposition Mask Apparatus)

The deposition mask apparatus 10 is described herebelow. As shown in Fig. 1A, the deposition mask apparatus comprises a deposition mask 20 and a frame 15 that supports the deposition mask 20. The frame 15 has an opening 15a that overlaps with a part of the deposition mask 20. The frame 15 supports the deposition mask 20 in a taut state so that the deposition mask is not bent. As shown in Fig. 1A, the deposition mask apparatus 10 is disposed in the deposition apparatus 90 such that the deposition mask 20 faces a substrate which is an object onto which the deposition material 98 is deposited, such as an organic EL substrate 92. As described above, the organic EL substrate 92 is placed on the deposition mask apparatus 10 by the holding member 92A holding the organic EL substrate 92. In the description below, a surface of the deposition mask 20, which is closer to the organic EL substrate 92, is referred to as first make 20a, and a surface positioned opposite to the first surface 20a is referred to as second surface 20b.

As shown in Fig. 1A, the deposition mask apparatus 10 may comprise a magnet 93 disposed on a surface of the organic EL substrate 92, which is opposed to the deposition mask 20. Due to the provision of the magnet 93, the deposition mask 20 can be attracted toward the magnet 93 so that the deposition mask 20 can be tightly in contact with the organic EL substrate 92.

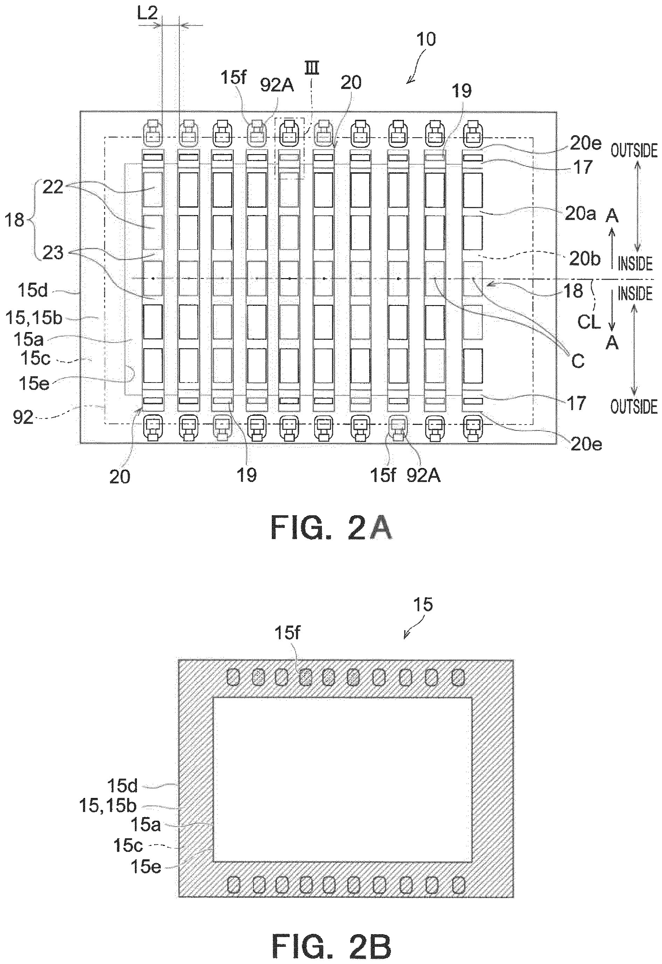

Fig. 2A is a plane view of the deposition mask 10, the organic EL substrate 92 and the holding member 92A shown in Fig. 1A, which are seen from the side of the first surface 20a of the deposition mask 20. As shown in Fig. 2A, the deposition mask apparatus 10 comprises a plurality of deposition masks 20 having a substantially rectangular shape in plan view. Each deposition mask 20 is fixed on the frame 15 by welding, at below-described joint portions 19 which are positioned near a pair of ends 20e in a longitudinal direction of the deposition mask 20.

As shown in Fig. 1A, the deposition mask 20 includes a plurality of through-holes 25 passing through the deposition mask 20. The deposition material, which has evaporated from the crucible 94 to reach the deposition mask apparatus 10, adheres to the organic EL substrate 92 through the through-holes 25 of the deposition mask 20. Thus, the deposition material 98 can be deposited on the surface of the organic EL substrate 92 in a desired pattern corresponding to the positions of the through-holes 25 of the deposition mask 20.

Fig. 1B is a sectional view showing an organic EL display device 10 manufactured with the use of the deposition apparatus 90 shown in Fig. 1A. The organic EL display device 100 comprises the organic EL substrate 92 and patterned pixels containing the deposition material 98.

When colored display by a plurality of colors is desired, the deposition apparatuses 90 provided with deposition masks 20 corresponding to respective colors are respectively prepared, and the organic EL substrate 92 is put into the respective deposition apparatuses 90 in sequence. Thus, for example an organic luminescence material for red color, an organic luminescence material for green color, and an organic luminescence material for blue color can be deposited onto the organic EL substrate 92 in sequence.

The deposition process is sometimes performed inside the deposition apparatus 90 in a high-temperature atmosphere. In this case, during the deposition process, the deposition masks 20, the frame 15 and the organic EL substrate 92, which are held inside the deposition apparatus 90, are also heated. At this time, each of deposition mask 20, the frame 15 and the organic EL substrate 92 develop dimensional change behaviors based on their respective thermal expansion coefficients. In this case, when the thermal expansion coefficients of the deposition mask 20, the frame 15 and the organic EL substrate 92 largely differ from one another, positioning displacement occurs because of the difference in dimensional change. As a result, the dimensional precision and the positional precision of the deposition material to be adhered to the organic EL substrate 92 lower.

In order to avoid this problem, the thermal expansion coefficients of the deposition mask 20 and the frame 15 are preferably equivalent to the thermal expansion coefficient of the organic EL substrate 92. For example, when a glass substrate is used as the organic EL substrate 92, an iron alloy containing nickel can be used as a main material of the deposition mask 20 and the frame 15. For example, an iron alloy containing not less than 30% by mass and not more than 50% by mass of nickel can be used as a material of the metal plate constituting the deposition masks 20. Concrete examples of an iron alloy containing nickel may be an invar material containing not less than 34% by mass and not more than 38% by mass of nickel, a super invar material containing cobalt in addition to not less than 30% by mass and not more than 34% by mass of nickel, or a low thermal expansion Fe-Ni based plated alloy containing not less than 48% by mass and not more than 54% by mass of nickel.

During the deposition step, if the deposition mask 20, the frame 15 and the organic EL substrate 92 do not reach high temperatures, it is not particularly necessary that the thermal expansion coefficients of the deposition mask 20 and the frame 15 are equivalent to the thermal expansion coefficient of the organic EL substrate 92. In this case, a material other than the aforementioned iron alloy can be used as a material for forming the deposition mask 20. For example, it is possible to use an iron alloy other than the iron alloy containing nickel, such as an iron alloy containing chrome. As an iron alloy containing chrome, an iron alloy that is so-called stainless can be used, for example. In addition, it is possible to use alloy other than an iron alloy, such as nickel, or nickel-cobalt alloy.

### (Frame)

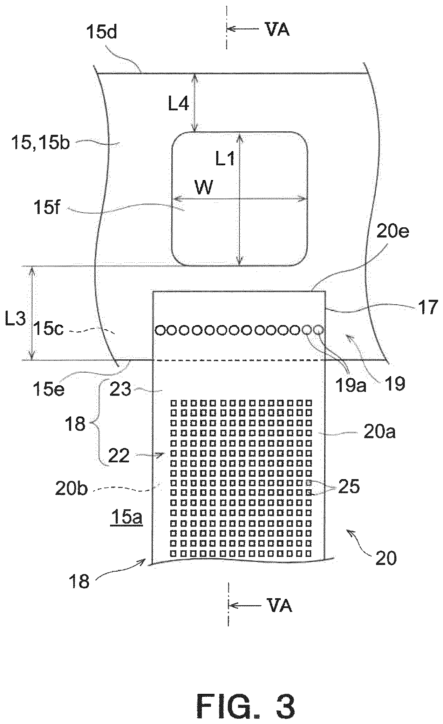

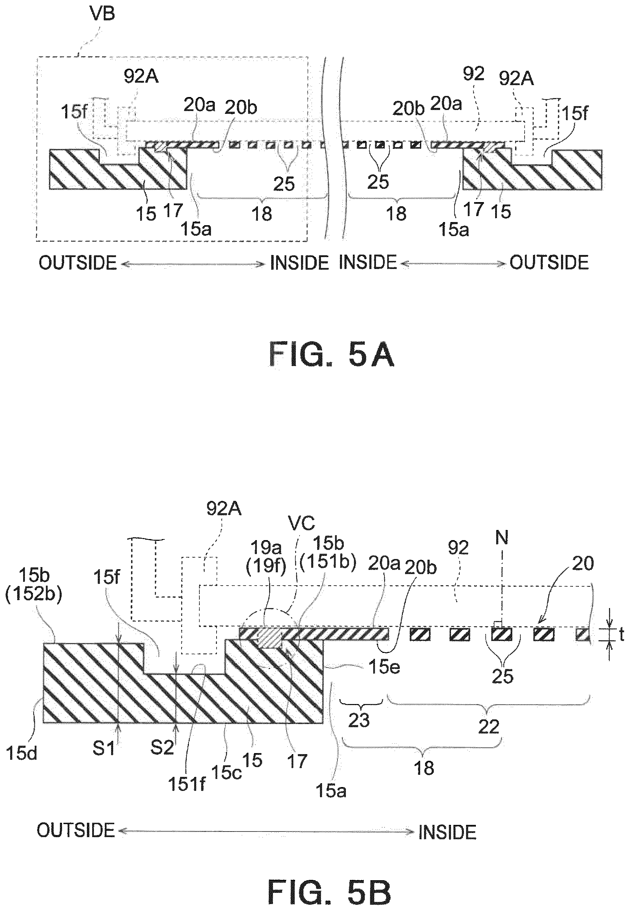

Next, the frame 15 is described in detail with further reference to Figs. 2B, 3, 5A and 5B, in addition to Fig. 2A. Fig. 2B is a plan view showing the frame 15. Fig. 3 is a plan view showing in enlargement a part of the deposition mask 10 shown in Fig. 2A. Fig. 5A is a sectional view of the deposition mask apparatus 10 of Fig. 3 seen from a VA-VA direction. Fig. 5B is a sectional view showing in enlargement the deposition mask apparatus of Fig. 5A (a sectional view corresponding to a VB part of Fig. 5A. As shown in Figs. 2A, 2B, 3 and 5B, the frame 15 has a front surface 15b (i.e., a third surface) facing the second surface 20b of the deposition mask 20, a rear surface 15c (i.e., a fourth surface) opposed to the front surface 15b, an outside surface 15d spreading between the front surface 15b and the rear surface 15c, and an inside surface 15e spreading between the front surface 15b and the rear surface 15c to face an opening 15a. As shown in Fig. 5B, when seen in a section along a normal direction N of the first surface 20a of the deposition mask 20, the front surface 15b and the rear surface 15c extend parallel to each other in a direction orthogonal to the normal direction N. When seen in a section along the normal direction N of the first surface 20a of the deposition mask, the outside surface 15d and the inside surface 15e extend in the normal direction N and connect to the front surface 15b and the rear surface 15c orthogonally thereto. During the deposition step, the deposition material 98 having evaporated from the crucible 94 adheres to the organic EL substrate 92 through the opening 15a of the frame 15. When seen in a section along the normal direction N of the first surface 20a of the deposition mask 20, the outside surface 15d and the inside surface 15e of the frame 15 may be inclined from the normal direction N or may be curved.

In addition, a plurality of accommodation parts 15f may be formed in the surface 15b of such a frame 15 at positions apart from the opening 15a. The plurality of accommodation parts 15f may be posited outside the below-described joint portions 19, and a surface 151f (i.e., a fifth surface) of the accommodation part may be positioned nearer to the rear surface 15c (i.e., the fourth surface) of the frame 15 to the front surface 15b (i.e., the third surface) thereof. The accommodation part 15f is configured to be capable of accommodating at least a part of the holding member 92A, when the organic EL substrate 92 held by the holding member 92A is combined with the deposition mask apparatus 10 (see Figs. 5A and 5B). Thus, when the organic EL substrate 92 is placed on the deposition mask apparatus 10, it can be prevented that the holding member 92A from interfering wit the frame 15, whereby the organic EL substrate 92 can be placed on a desired position with respect to the deposition mask apparatus 10. In this embodiment, such an accommodation part 15f is constituted by a recess formed in the front surface 15b. In this case, a front surface 151b of the front surface 15b, which is positioned inside the accommodation part 15f, and a front surface 152b thereof, which is positioned outside the accommodation part 15f, are positioned on the same surface, when seen along the normal direction N of the first surface 20a.

In order to prevent interference of the holding member 92A with the frame 15, it can be conceived to reduce a width of the frame 15 (a distance between the outside surface 15d and the inside surface 15e) so that the holding member 92A does not interfere with the frame 15, other than the provision of the aforementioned plurality of accommodation parts 15f. On the other hand, by discretely providing the front surface 15b of the frame 15 with a plurality of the accommodation parts 15f capable of accommodating at least a part of the holding member 92A, parts of the frame 15, each of which has a thickness S1 (see Fig. 5B) and is free of the accommodation part 15f, can be distributed over all the area of the frame 15. Thus, lowering of strength of the frame 15, which is caused by providing the frame 15 with the accommodation parts 15f, can be prevented. Namely, as compared with a case in which the width of the frame 15 is reduced, a planar dimension of a part of the frame 15, which has the thickness S1 (see Fig. 5B), can be increased in plan view. Thus, lowering of the strength such as rigidity of the frame 15 can be effectively prevented. As a result, when the frame 15 supports the deposition mask 20 in a taut state, it can be prevented that the frame 15 is deformed such as bent by a force applied from the deposition mask 20. Therefore, the deposition material 98 can be precisely deposited onto the organic EL substrate 92 with the use of the deposition mask 20 supported on the frame 15.

In Fig. 5B, the reference numeral S2 depicts the thickness of the frame 15 at which the accommodation part 15f is provided. The thickness S2 is determined depending on a size of the holding member 92A, in such a manner that the holding member 92A can be prevented from interfering with the frame 15. For example, the thickness S2 may be not less than 2 mm, not less than 5 mm, not less than 7 mm, or not less than 10 mm. In addition, the thickness S2 may be not more than 20 mm, not more than 18 mm, not more than 15 mm, or not more than 12 mm. A range of the thickness S2 may be determined by combining any one of the above upper limit candidate values and any one of the above lower limit candidate values. For example, the range of the thickness S2 may be not less than 2 mm and not more than 20 mm, not less than 5 mm and not more than 18 mm, not less than 7 mm and not more than 15 mm, or not less than 10 mm and not more than 12 mm. In addition, the range of the thickness S2 may be determined by combining any two of the above upper limit candidate values. For example, the range of the thickness S2 may be not less than 15 mm and not or than 18 mm. In addition, the range of the thickness S2 may be determined by combining any two of the above lower limit candidate values. For example, the range of the thickness S2 may be not less than 7 mm and not more than 10 mm.

The thickness S1 of a part of the frame 15, which is not provided with the accommodation part 15f, is determined so as to prevent deformation such as bending of the frame 15. For example, the thickness S1 may be not less than 5 mm, not less than 10 mm, not less than 15 mm, or not less than 20 mm. In addition, the range of the thickness S1 may be not more than 35 mm, not more than 30 mm, not more than 25 mm, or not more than 20 mm. A range of the thickness S1 may be determined by combining any one of the above upper limit candidate values and any one of the above lower limit candidate values. For example, the range of the thickness S1 may be not less than 5 mm and not more than 35 mm, not less than 10 mm and not more than 30 mm, or not less than 15 mm and not more than 25 mm. In addition, the range of the thickness S1 may be determined by combining any two of the above upper limit candidate values. For example, the range of the thickness S1 may be not less than 20 mm and not or than 30 mm. In addition, the range of the thickness S1 may be determined by combining any two of the above lower limit candidate values. For example, the range of the thickness S1 may be not less than 10 mm and not more than 15 mm. In addition, the thickness S1 may be determined depending on the thickness S2 of the part of the frame 15, which is provided with the accommodation part 15f. For example, the thickness S1 may be not less than 1.5 × S2 and not more than 3.0 × S2.

Preferably, a ratio (referred to also as an accommodation part ratio herebelow) of a planar dimension of the parts (satin-like parts shown in Fig. 2B) at which the plurality of accommodation parts 15f are provided relative to a whole planar dimension of the front surface 15b of the frame 15 (diagonal-line part shown in Fig. 2B) is determined so as to prevent the frame 15 from deforming such as bending. For example, the accommodation part ratio may be not less than 5%, not less than 7%, or not less than 9%. In addition, the accommodation part ratio may be not more than 15%, not more than 13%, not more than 9%, or not more than 11%. A range of the accommodation part ratio may be determined by combining any one of the above upper limit candidate values and any one of the above lower limit candidate values. For example, the range of the accommodation part ratio may be not less than 5% and not more than 15%, not less than 7% and not more than 13%, or not less than 9% and not more than 11%. In addition, the range of the accommodation part ratio may be determined by combining any two of the above upper limit candidate values. For example, the range of the accommodation part ratio may be not less than 11% and not more than 15%. In addition, the rang of the accommodation part ratio may be determined by combining any two of the above lower limit candidate values. For example, the range of the accommodation part ratio may be not less than 5% and not more than 9%.

In this embodiment, the plurality of accommodation parts 15f may be formed between the outside surface 15d and the inside surface 15e. To be more specific, the plurality of accommodation parts 15f according to this embodiment are formed outside the pair of ends 20e of the deposition mask 20. By forming the plurality of accommodation parts 15f between the outside surface 15b and the inside surface 15e, an area having the thickness S1 can be ensured outside the accommodation parts 15f, whereby lowering of the strength of the frame 15 can be effectively prevented. Herein, as shown by the arrow A in Fig. 2A, the "outside" means the side which goes away from a centerline CL of the deposition mask 20 in the longitudinal direction of the deposition mask 20. In addition, the "inside" means the side which comes near to the centerline CL of the deposition mask 20 in the longitudinal direction of the deposition mask 20. Herein, the centerline CL of the deposition mask is, out of straight lines extending orthogonal to the longitudinal direction of the deposition mask 20, a straight line that passes an intermediate point C (see Fig. 2A) that bisects a distance between the pair of ends 20e in the longitudinal direction of the deposition mask 20.

As shown in Fig. 2A, the plurality of accommodation parts 15f are arranged side by side along sides of the opening 15a delimited by the inside surface 15e. In the example shown in Fig. 2A, the opening 15a has a rectangular shape having four sides, and the plurality of accommodation parts 15f are arranged side by side along the pair of sides of the sides of the opening 15a. In addition, the plurality of deposition masks 20 are attached to the frame 15 such that their ear portions 17 are arranged side by side along the same side of the opening 15a along which the plurality of accommodation parts 15f are arranged side by side. Although not shown, the plurality of accommodation parts 15f may be arranged side by side along a side the opening 15a that is different from the side along which the ear portions 17 of the plurality of deposition masks 20 are arranged side by side.

The number and the dimensions of the accommodation parts 15f can be suitably determined depending on the dimensions of the holding member 92A that holds the organic EL substrate 92, as long as, when the organic EL substrate 92 is installed on the frame 15 (when the organic EL substrate 92 comes into contact with the first surface 20a of the deposition mask 20), the holding member 92A does not come into contact with the accommodation parts 15f. For example, a length L1 (length along the longitudinal direction of the deposition mask 20 (see Fig. 3)) of the accommodation part 15f may be not less than 15 mm and not more than 50 mm, for example, and a width W (length along a width direction of the deposition mask 20 (see Fig. 3)) may be not less than 5 mm, not less than 10 mm, not less than 15 mm, not less than 20 mm, or not less than 25 mm. In addition, the width W may be not more than 50 mm, not more than 45 mm, not more than 40 mm, or not more than 35 mm. A range of the width W may be determined by combining any one of the above upper limit candidate values and any one of the above lower limit candidate values. For example, the range of the width W may be not less than 5 mm and not more than 50 mm, not less than 10 mm and not more than 45 mm, or not less than 15 mm and not more than 40 mm. In addition, the range of the width W may be determined by combining any two of the above upper limit candidate values. For example, the range of the width W may be not less than 35 mm and not more than 45 mm. In addition, the range of the width W may be determined by combining any two of the above lower limit candidate values. For example, the range of the width W may be not less than 10 mm and not more than 20 mm. In addition, a distance L2 (see Fig. 2A) between the accommodation parts 15f adjacent to each other may, for example, be not less than 50 mm, not less than 80 mm, not less than 100 mm, or not less than 130 mm. In addition, the distance L2 may be not more than 250 mm, not more than 220 mm, not more than 200, or not more than 180 mm. A range of the distance L2 may be determined by combining any one of the above upper limit candidate values and any one of the above lower limit candidate values. For example, the range of the distance L2 may be not less than 50 mm and not more than 250 mm, not less than 80 mm and not more than 220 mm, or not less than 100 mm and not more than 200. In addition, the range of the distance L2 may be determined by combining any two of the above upper limit candidate values. For example, the range of the distance L2 may be not less than 200 and not more than 220. In addition, the range of the distance L2 may be determined by combining any two of the above lower limit candidate values. For example, the range of the distance L2 may be nor less than 130 mm and not more than 150 mm.

In Fig. 2A, a cycle of the plurality of accommodation parts 15f arranged side by side along the side of the opening 15a corresponds to a cycle of the plurality of deposition masks 20 arranged side by side along the same side of the opening 15a, but the present invention is not limited thereto. Although not shown, the cycle of the plurality of accommodation parts 15f may differ from the cycle of the plurality of deposition masks 20.

In addition, a distance L3 (see Fig. 3) from the inside surface 15e of the frame 15 to the accommodation part 15f may be, for example, not less than 1 mm and not more than 20 mm, and preferably not less than 3 mm and not more than 20 mm. By setting the distance L3 from the inside surface 15e of the frame 15 to the accommodation part 15f to be not less than 3 mm, a planar dimension of the joint portion 19 an be sufficiently ensured, whereby the strength of the joint portion 19 can be increased. In addition, by setting the distance L3 from the inside surface 15e of the frame 15 to the accommodation part 15f to be not more than 20 mm, a planer dimension of the opening 15a can be enlarged, whereby an area effective to deposition can be enlarged. In addition, the distance L3 from the inside surface 15e of the frame 15 to the accommodation part 15f may be ,for example, not less than 1 mm, not less than 3 mm, not less than 5 mm, or not less than 10 mm. In addition, the distance L3 may be not more than 20 mm, not more than 18 mm, or not more than 15 mm. A range of the distance L3 may be determined by combining any one of the above upper limit candidate values and any one of the above lower limit candidate values. For example, the range of the distance L3 may be not less than 1 mm and not more than 20 mm, not less than 3 mm and not more than 18 mm, or not less than 5 mm and not more than 15 mm. In addition, the range of the distance L3 may be determined by combining any two of the above upper limit candidate values. For example, the range of the distance L3 may be not less than 15 mm and not more than 18 mm. In addition, the range of the distance L3 may be determined by combining any two of the above lower limit candidate values. For example, the range of the distance L3 may be not less than 3 mm and not more than 10 mm.

Further, a distance L4 (see Fig. 3) from the outside surface 15d of the frame 15 to the accommodation part 15f may be, for example, not less than 10 mm and not more than 80 mm, preferably not less than 30 mm. By setting the distance L4 from the outside surface 15d of the frame 15 to the accommodation part 15f to be not less than 30 mm, lowering of the strength of the frame 15 can be prevented. In addition, the distance L4 from the outside surface 15d of the frame 15 to the accommodation part 15f may be, for example, not less than 10 mm, not less than 20 mm, not less than 30 mm, or not less than 40 mm. In addition, the distance L4 from the outside surface 15d of the frame 15 to the accommodation part 15f may be not more than 80 mm, not more than 70 mm, not more than 60 mm, or not more than 50 mm. A range of the distance L4 may be determined by combining any one of the above upper limit candidate values and any one of the above lower limit candidate values. For example, the distance L4 may be not less than 10 mm and not more than 80 mm, not less than 20 mm and not more than 70 mm, or not less than 30 mm and not more than 60 mm. In addition, the range of the distance L4 may be determined by combining any two of the above upper limit candidate values. For example, the range of the distance L4 may be not less than 50 mm and not more than 80 mm. In addition, the range of the distance L4 may be determined by combining any two of the above lower limit candidate values. For example, the range of the distance L4 may be not less than 10 mm and not more than 40 mm.

As shown in Figs. 2A to 4A, the accommodation part 15f has a rectangular shape in plan view. However, the the accommodation part 15f may have any shape, for example, a circular shape or an elliptic shape in plan view, or a polygonal shape such as a hexagonal shape or an octagonal shape. In addition, the respective accommodation parts 15f may have shapes different from one another. For example, the accommodation parts 15f may respectively have a circular shape, an elliptic shape, or a polygonal shape such as a hexagonal shape or an octagonal shape in plan view. In addition, such a accommodation part 15f may pass through the frame 15. In this case, there may be formed an accommodation part 15f that passes through the frame 15, and an accommodation part 15f that does not pass through the frame 15.

### (Deposition Mask)

Next, the deposition mask 20 is described in detail. As shown in Fig. 2A, the deposition mask 20 comprises a pair of ear portions 17 that constitute a pair of ends 20e in the longitudinal direction of the deposition mask 20, and an intermediate portion 18 that is posited between the pair of ear portions 17.

### (Ear Portion)

Firstly, the ear portion 17 is described in detail. The ear portion 17 is a part of the deposition mask 20, which is fixed to the frame 15. In this embodiment, the ear portion 17 is fixed to the frame 15 by welding, on the side of the second surface 20b. In the description below, a part of the ear portion 17 and a part of the frame 15, which are joined to each other by welding, are referred to as a joint portion 19. The joint portion 19 may be positioned between the opening 15a of the aforementioned frame 15 and the accommodation part 15f.

The joint portion 19 formed in the ear portion 17 includes a welding taint 19a. The welding taint 19a is a trace formed in the first surface 20a of the deposition mask 20, which is caused by welding the second surface 20b of the deposition mask 20 to the frame 15. For example, as shown in Fig. 3, the joint portion 19 includes a plurality of dot-like welding taints 19a arranged side by side along the width direction of the deposition mask 20. Such plurality of dot-like welding taints 19a are formed by intermittently applying a laser beam like dots to the ear portion 17 at respective positions along the width direction of the deposition mask 20.

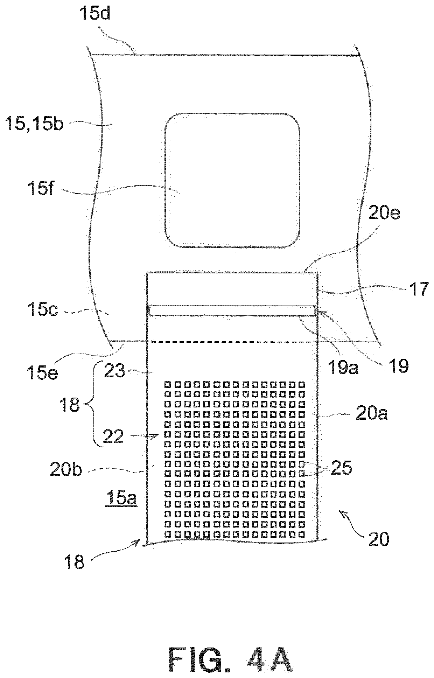

Arrangement and a shape of the welding taint 19a in plan view are not specifically limited. For example, as shown in Fig. 4A, the welding taint 19a may extend linearly along the width direction of the deposition mask 20. For example, such welding taint 19a may be formed by continuously applying a laser beam like a line to the ear portion 17 at respective positions along the width direction of the deposition mask 20. In this case, since the welding taint 19a extends linearly along the width direction of the deposition mask 20, the welding strength can be increased.

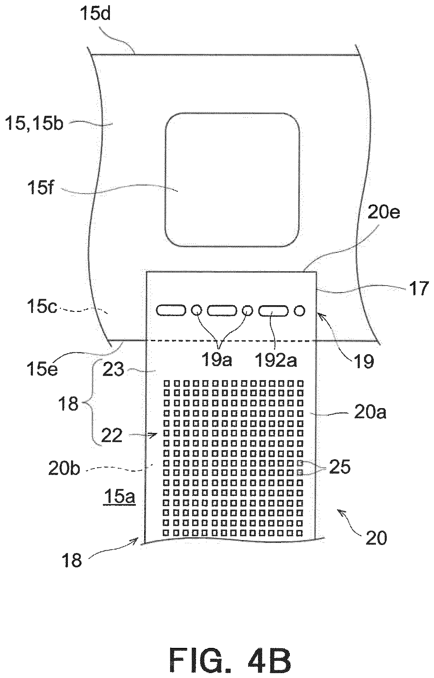

In addition, for example, as shown in Fig. 4B, the welding taint 19a may include a first welding taint 191a formed like a dot and a second welding taint 192a formed like a line. In the illustrated example, the welding taint 19a includes a plurality of first welding taints 191a and a plurality of second welding taints 192a. The first welding taints 191a and the second welding taints 192a are regularly, i.e., alternately arranged among the width direction of the deposition mask 20. In this case, the shapes of the respective second welding taints 192 may be overlapped with each other, for example. In addition, the number of the first welding taint 191a may be only one, and the number of the second welding taint 192a may be only one. Also in this case, since the welding taint 19a includes the linearly formed second welding taint 192a, the welding strength can be increased.

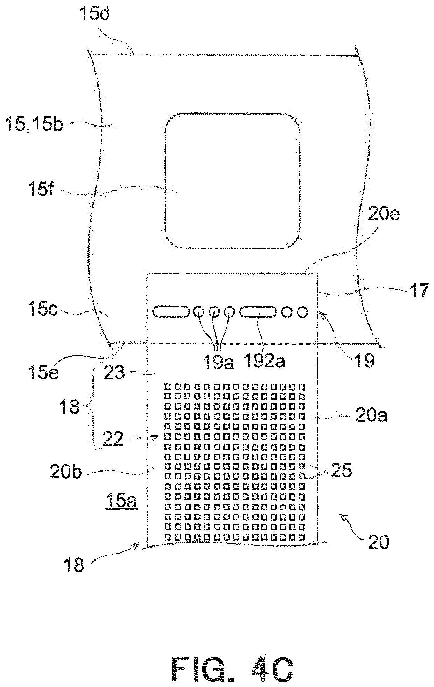

In addition, as shown in Fig. 4C, the first welding taints 191a and the second welding taints 192a may be irregularly arranged along the width direction of the deposition mask 20. In the illustrated example, the numbers of the first welding taints 191a arranged between the second welding taints 192a adjacent to each other in the width direction of the deposition mask 20 differ from each other. Also in this case, the shapes of the respective second welding taints 192a may differ from each other, for example. In addition, the numbers of the first welding taints 191a arranged between the second welding taints 192a adjacent to each other in the width direction of the deposition mask 20 are optional. In this case, the density of the welding taints 19a can be selectively increased at a part where the welding density of the deposition mask 20 is desired to be increased.

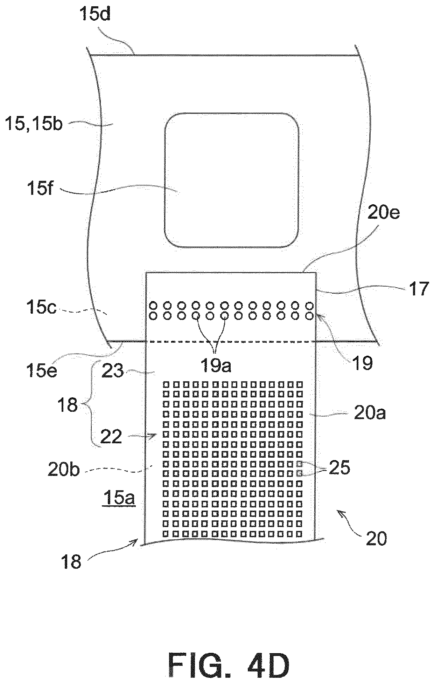

In addition, for example, as shown in Fig. 4D, a plurality of dot-like welding taints 19a may be formed in a plurality of rows along the width direction of the deposition mask 20. In the illustrated example, the welding taints 19a are formed in two rows along the width direction of the deposition mask 20. However, the welding taints 19a may be formed in three rows or in four rows along the width direction of the deposition mask 20. In this case, since the plurality of dot-like welding taints 19a are formed in a plurality of rows along the width direction of the deposition mask, the welding strength can be increased.

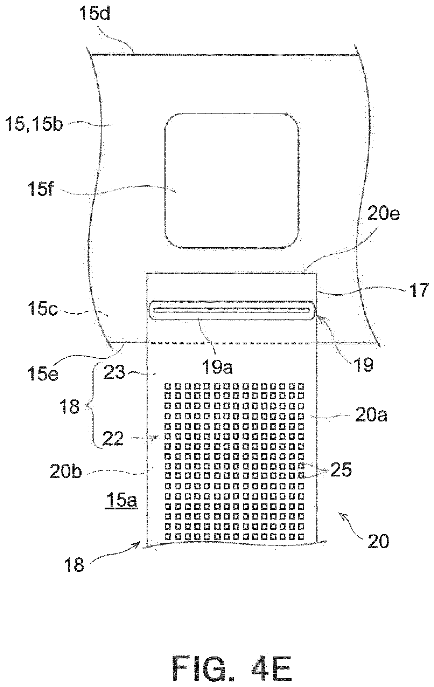

Further, for example, as shown in Fig. 4E, the welding taint 19a may be formed like a frame along the width direction of the deposition mask 20. Also in this case, since the welding taint 19a is formed along the width direction of the deposition mask 20, the welding strength can be increased.

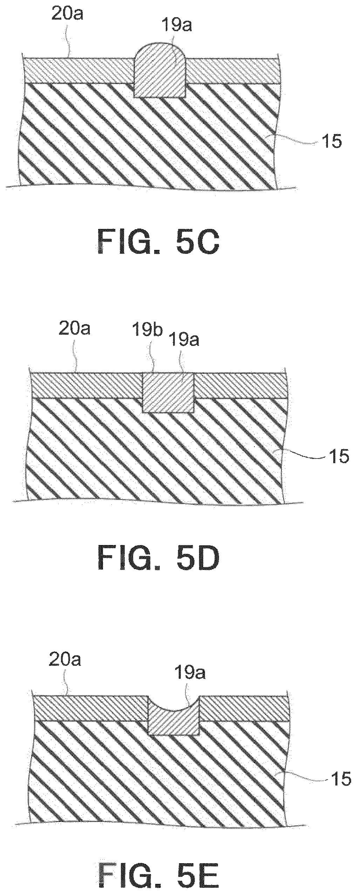

In addition, as shown in Figs. 5A and 5B, the welding taint 19a extends from the first surface 20a of the ear portion 17 to reach the frame 15 through the second surface 20b. The welding taint 19a is a part of the ear portion 17 of the deposition mask and the frame 15, which was melted (i.e., melted area 19f) upon welding and is then solidified, and includes a part of the ear portion 17, which extends from the first surface 20a to reach the second surface 20b, and a part of the frame 15. The welding taint 19a joins the ear portion 17 of the deposition mask 20 and the frame 15 to each other. In the welding taint 19a, when a temperature of the melt area 19f lowers after welding so that the melt area 19f solidifies, a material crystallizes. For example, the welding taint 19a includes crystal grains striding the ear portion 17 and frame 15. As shown in Fig. 5C, for example, the welding taint 19 may be formed to project from the first surface 20a of the deposition mask 20.

In addition, as shown in Fig. 5D, the welding taint 19a may be formed such that an upper surface 19b of the welding taint 19a is positioned on the same plane as that of the first surface 20a of the deposition mask 20. Further, as shown in Fig. 5E, the welding taint 19a may be recessed toward the second surface 20b with respect to the first surface 20a of the deposition mask 20. In these cases, when the deposition material 98 is deposited onto the organic EL substrate 92, adhesion between the deposition mask 20 and the organic EL substrate 92 can be improved.

In Figs. 5A and 5B, the organic EL substrate 92, which is in tight contact with the deposition mask 20 during the deposition process, is shown by dotted lines. As shown in Figs. 5A and 5B, in this embodiment, the organic EL substrate 92 extends outside a part of the deposition mask 20, at which the joint portion 19 is formed. In addition, when the organic EL substrate 92 is installed on the frame 15, the organic EL substrate 92 is installed on the frame 15 while it is being held by the holding member 92A. The holding member 92A may be detached from the organic EL substrate 92, when the deposition material 98 is deposited onto the organic EL substrate 92.

Although not shown, as described below, after the deposition mask 20 has been welded to the frame 15, the ear portion 17 is cut between the opening 15a of the frame 15 and the accommodation part 15f so as to be partly removed. Thus, in this embodiment, the pair of ends 20e in the longitudinal direction of the deposition mask 20 are positioned between the opening 15a of the frame 15 and the accommodation parts 15f.

### (Intermediate Portion)

Next, the intermediate portion 18 is described. As shown in Figs. 2A, 3, 5A and 5B, the intermediate portion includes an effective area 22 in which the through-holes 25 extending from the first surface 20a to reach the second surface 20b are formed, and a peripheral area 23 surrounding the effective area 22. The peripheral area 23 is an area for supporting the effective area 22, and is not an area through which the deposition material, which is intended to be deposited onto the organic EL substrate 92, passes. For example, the effective area 22 is an area of the deposition mask 20, which faces a display area of the organic EL substrate 92.

As shown in Fig. 2A, the effective area 22 has a profile of a substantially quadrangular shape in plan view, more precisely a substantially rectangular shape in plan view. Although not shown, each effective area 22 may have a profile of various shapes depending on a shape of the display area of the organic EL substrate 92. For example, each effective area 22 may have a profile of a circular shape.

As shown in Fig. 2A, the intermediate portion 18 includes a plurality of effective areas 22 that are arranged at predetermined intervals therebetween along the longitudinal direction of the deposition mask 20. One effective area 22 corresponds to a display area of one organic EL display device 100. Thus, the deposition mask apparatus 10 shown in Fig. 1A enables a multifaceted deposition of the organic EL display devices 100.

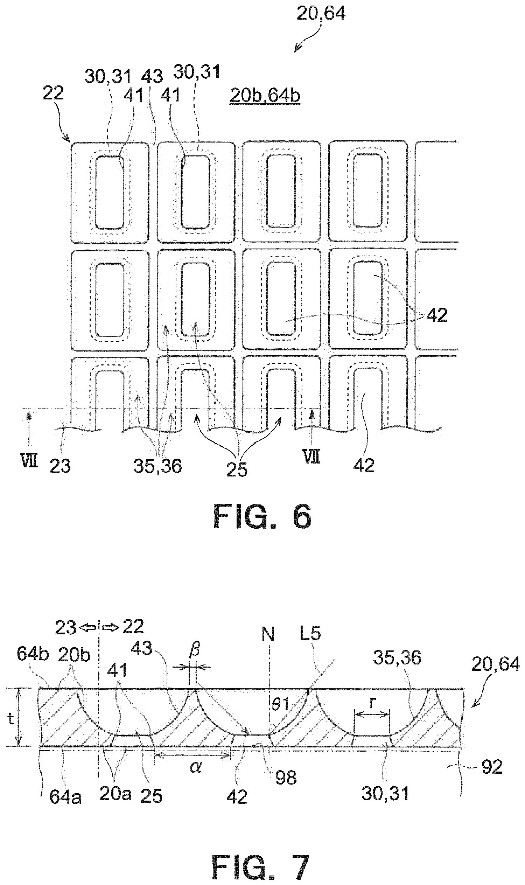

The intermediate portion 18 is described in detail below. Fig. 6 is a plan view showing in enlargement the intermediate portion 18. Fig. 7 is a sectional view of the intermediate portion 18 of Fig. 6 seen from the VII-VII direction. As shown in Fig. 6, the plurality of through-holes 25 are arranged in the effective area 22 at predetermined pitches along two directions orthogonal to each other.

The effective area 22 is described in detail below. Fig. 6 is a plan view showing in enlargement the effective area 22 from the side of the second surface 20b of the deposition mask 20. As shown in Fig. 6, in the illustrated example, the plurality of through-holes 25 formed in each effective area 22 are arranged at predetermined pitches along two directions orthogonal to each other.

Fig. 7 is a sectional view along the VII- VII direction of the effective area 22 of Fig. 6. As shown in Fig. 7, the plurality of through-holes 25 pass through the deposition mask 20 from the first surface 20a of the deposition mask 20 to the second surface 20b thereof. In the illustrated example, as shown below in detail, first recesses 30 are formed by etching in a first surface 64a of a metal plate 64, which is one side in the normal direction N of the first surface 20a of the deposition mask 20. Second recesses 35 are formed in a second surface 64b of the metal plate e64, which is the other side in the normal direction N. Each of the first recess 30 is connected to each of the second recess 35, so that the second recess 35 and the first recess 30 are formed to communicate with each other. The through-hole 25 is composed of the second recess 35 and the first recess 30 connected to the second recess 35. As shown in Figs. 6 and 7, a wall surface 31 of the first recess 30 and a wall surface 36 of the second recess 35 are connected through a circumferential hole connection portion 41. The connection portion 41 defines a through-portion 42 at which a planar dimension of the through-hole 25 is minimum in plan view of the deposition mask 20.

As shown in Fig. 7, the adjacent two through-holes 25 in the first surface 20a of the deposition mask 20 are spaced apart from each other along the first surface 64a of the metal plate 64. Also on the side of the second surface 20b of the deposition mask 20, the adjacent two through second recesses 35 may be spaced apart from each other along the second surface 64b of the metal plate 64. Namely, the second surface 64b of the metal plate 64 may remain between the adjacent two second recesses 35. In the description below, this portion of the effective area 22 of the second surface 64b of the metal plate 64, which is not etched and thus remains, is also referred to as a top portion 43. By manufacturing the deposition mask 20 such that such a top portion 43 remains, the deposition mask 20 can have a sufficient strength. Thus, it can be prevented that the deposition mask 20 is damaged during conveyance, for example. However, when a width β of the top portion 43 is too large, there is a possibility that shadow occurs in the deposition step, which lowers utilization efficiency of the deposition material 98. Thus, the deposition mask 20 is preferably manufactured such that the width β of the top portion 43 is excessively large.

When the deposition mask apparatus 10 is received in the deposition apparatus 90 as shown in Fig. 1A, the first surface of the deposition mask 20 faces the organic EL substrate 92 as shown by two-dot chain lines in Fig. 7, and the second surface 20b of the deposition mask 20 is positioned on the side of the crucible 94 holding the deposition material 98. Thus, the deposition material 98 adheres to the organic EL substrate 92 through the second recess 35 whose opening area gradually decreases. As indicated by the arrow in Fig. 7 extending from the second surface 20b toward the first surface 20a, the deposition material 98 not only moves from the crucible 94 toward the organic EL substrate 92 along the normal direction N of the organic EL substrate 92, but also sometimes moves along a direction largely inclined with respect to the normal direction N of the organic EL substrate 92. At this time, when the thickness of the deposition mask 20 is large, most of the diagonally moving deposition material 98 reaches the wall surface 36 of the second recess 35 to adhere thereto, before the deposition material 98 passes through the through-holes 25 to reach the organic EL substrate 92. Thus, in order to improve utilization efficiency of the deposition material 98, it is preferable that the thickness t of the deposition mask 20 is reduced so that heights of the wall surface 36 of the second recess 35 and the wall surface 31 of the first recess 30 are reduced. Namely, it can be said that it is preferable to use the metal plate e64, which has the thickness t as small as possible, as long as the strength of the deposition mask 20 is ensured. In consideration of this point, the thickness t of the deposition mask 20 is, for example, not more than 30 µm), preferably not more than 25 µm, or further preferably not more than 20 µm. On other hand, when the thickness of the deposition mask 20 is excessively reduced, the strength of the deposition mask 20 lowers so that the deposition mask 20 is likely to be damaged and/or deformed. In consideration of this point, the thickness t of the deposition mask 20 is preferably not less than 5 µm. The thickness t of the deposition mask may be not less than 8 µm, to less than 10 µm, not less than 12 µmm, not less than 13 µm or not less than 15 µm. A range of the thickness t may be determined by combining any one of the above upper limit candidate values and any one of the above lower limit candidate values. For example, the range of the thickness t of the deposition mask 20 may be not less than 13 µm and not more than 15 µm. The thickness t is a thickness of the peripheral area 23, i.e., a portion of the deposition mask 20, at which no first recess 30 and no second recess 35 is formed. Thus, it can also be said that the thickness t is a thickness of the metal plate 64.

In Fig. 7, a minimum angle defined by a line L5, which passes the connection portion 31 having the minimum opening area of the through-hole 25 and another given position of the wall surface 36 of the second recess 35, with respect to the normal direction N of the deposition mask 20 is represented by a reference numeral θ1. In order that the diagonally moving deposition material 98 can be caused to reach the organic EL substrate 92 with being caused to reach the wall surface 36 as much as possible, it is advantageous that the angle θ1 is increased. In order to increase the angle θ1, it is effective to reduce the aforementioned width β of the top portion 43, as well as to reduce the thickness t of the deposition mask 20.

In Fig. 7, the reference numeral α represents a width of a portion (hereinafter referred to also as "rib portion") of the effective area 22 of the first surface 64a of the metal plate 64, which is not etched and thus remains. A width α of the rib portion and a size r of the through-portion 42 are suitably determined depending on a size of an organic EL display device and the number of display pixels. For example, the width α of the rib portion is not less than 5 µm and not more than 40 µm, and the size r of the through-portion 42 is not less than 10 µm and not more than 60 µm.

In Figs. 6 and 7, the second surface 64b of the metal plate 64 remains between the adjacent two second recesses 35, but the present invention is not limited thereto. Although not shown, etching may be performed so that the adjacent two second recesses 35 are connected to each other. Namely, there may be a part where no second surface 64b of the metal plate 64 remains between the adjacent two second recesses 35.

Next, a method of manufacturing the deposition mask apparatus 10 is described. Firstly, a method of manufacturing a deposition mask 20 of the deposition mask apparatus 10 is described.

### Method of Manufacturing Deposition Mask

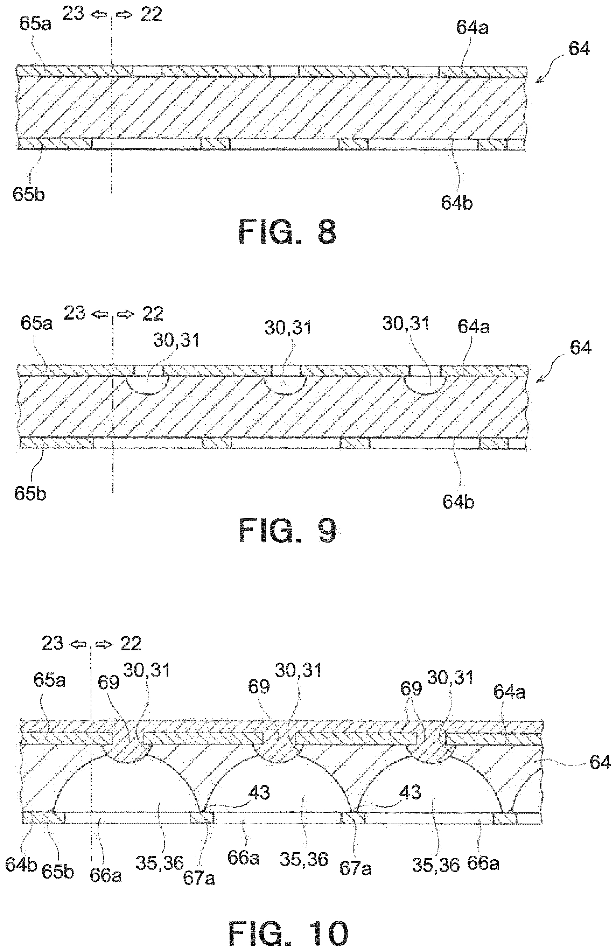

Firstly, a method of manufacturing the deposition mask 20 is described with reference mainly to Figs. 8 to 11. In this embodiment, a plurality of through-holes 25 corresponding to the plurality of deposition masks 20 are formed in the metal plate 64. In other words, the plurality of deposition masks 20 are allocated to the metal plate 64. Thereafter, a part of the metal plate 64, in which the through-holes 25 corresponding to one deposition mask 20 are formed, is separated from the metal plate 64. In this manner, the sheet-like deposition masks 20 can be obtained.

At this time, resist films containing a photosensitive resist material are formed on the first surface 64a of the meta plate 64 and the second surface 64b thereof. Then, the resist films are exposed and developed. Thus, as shown in Fig. 8, a first resist pattern 65a can be formed on the first surface 64a of the metal plate 64, and a second resist pattern 65b can be formed on the second surface 64b of the metal plate 64.

Then, as shown in Fig. 9, a first-surface etching step is performed, in which areas of the first surface 64a of the metal plate 64, which are not covered with the first resist pattern 65a, are etched by using a first etchant. Thus, a plurality of first recesses 30 are formed in the first surface 64a of the metal plate 64. The first etchant to be used is an etchant containing ferric chloride solution and hydrochloric acid, for example.

Then, as shown in Fig. 10, a second-surface etching step is performed, in which areas of the second surface 64b of the metal plate 64, which are not covered with the second resist pattern 65b, are etched so as to form the second recesses 35 in the second surface 64b. The second etching step is performed until the first recess 30 and the second recess 35 are communicated with each other so as to form the through-hole 25. Similarly to the aforementioned first etchant, a second etchant may be an etchant containing ferric chloride solution and hydrochloric acid, for example. At the second-surface etching step, as shown in Fig. 10, the first recesses 30 may be coated with a resin 69 resistant to the second etchant.

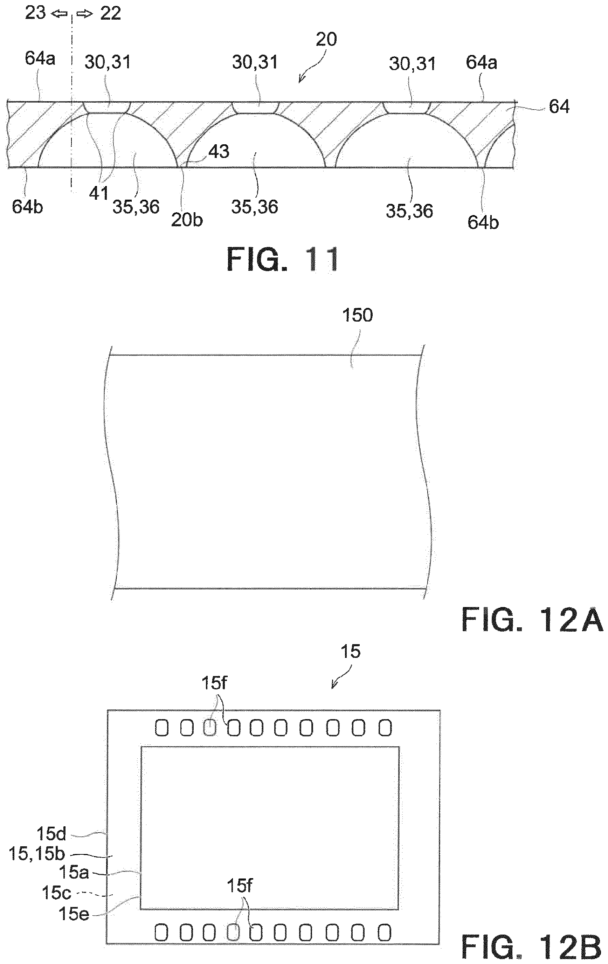

Thereafter, as shown in Fig. 11, the resin 69 is removed from the metal plate 64. For example, the resin 69 can be removed by using an alkali-based peeling liquid. When the alkali-based peeling liquid is used, as shown in Fig. 11, the resist patterns 65a, 65b are removed simultaneously with the removal of the resin 69. However, after the removal of the resin 69, the resist patterns 65a, 65b may be removed separately from the resin 69.

Thereafter, by separating a part of the metal plate 64, in which the through-holes 25 corresponding to one deposition mask 20 are formed, from the metal plate 64, the deposition mask 20 can be obtained.

Next, a method of manufacturing the frame 15 is described.

### Method of Manufacturing Frame

Firstly, a method of manufacturing the frame 15 is described with reference to Figs. 12A and 12B.

Firstly, as shown in Fig. 12A, a metal plate 150 is prepared.

Then, by machining such as cutting the metal plate 150, a frame 15 can be obtained. As shown in Fig. 12B, the frame 15 has a front surface 15b, a rear surface 15c opposed to the front surface 15b, an outside surface 15d spreading between the front surface 15b and the rear surface 15c, and an inside surface 15e spreading between the front surface 15b and the rear surface 15c at a position inside of the outside surface 15d, and facing an opening 15a. At this time, by machining such as cutting the metal plate 150, a plurality of accommodation parts 15f are formed at positions apart from the opening 15a in the front surface 15b of the frame 15. In this manner, the frame 15 is manufactured. The frame 15 may be manufactured with the use of a mold or a 3D printer.

### Method of Manufacturing Deposition Mask Apparatus

Then, a welding step of welding the deposition mask 20 obtained as above to the frame 15 is performed. Thus, the deposition mask apparatus 10 comprising the deposition masks 20 and the frame 15 can be obtained.

In this case, the deposition mask 20 is placed on the frame 15. Then, by a welding apparatus, not shown, a laser beam is applied from the side of the first surface 20a of the deposition mask 20. Thus, as shown in Figs. 5A and 5B, a part of the ear portion 17 of the deposition mask 20 and a part of the frame 15 are melt so that a melted area 19f, which extends from the first surface 20a of the ear portion 17 to reach the frame 15 through the second surface 20b, is formed. The melted area 19f strides over the ear portion 17 and the frame 15.

For example, as a laser beam, a YAG laser beam generated by a YAG laser system can be used. As a YAG layer system, a system including a crystal of YAG (yttrium aluminum garnet) doped with Nd (neodymium) as an oscillation medium can be used. In this case, laser light with a wavelength of about 1064 nm is generated as the fundamental. In addition, a second harmonic with a wavelength of about 532 nm is produced by passing the fundamental through a nonlinear optical crystal. In addition, a third harmonic with a wavelength of about 355 nm is produced by passing the fundamental and second harmonic through a nonlinear optical crystal.

The third harmonic of YAG laser light is likely to be absorbed by an iron alloy containing nickel. Thus, in order to efficiently melt a part of the ear portion 17 of the deposition mask 20 and a part of the frame 15, the laser beam preferably includes the third harmonic of YAG laser light.

After the application of the laser beam has ended, the temperature of the melted area 19f lowers, so that the melted area 19f solidifies into the welding taint 19a. Thus, the ear portion 17 of the deposition mask 20 and the frame are joined to each other by means of the welding taint 19a.

Thereafter, the ear portion of the deposition mask 20 is cut between the opening 15a of the frame 15 and the accommodation parts 15f, so that a part of the ear portion 17 is removed.

### Deposition Method of Deposition Material

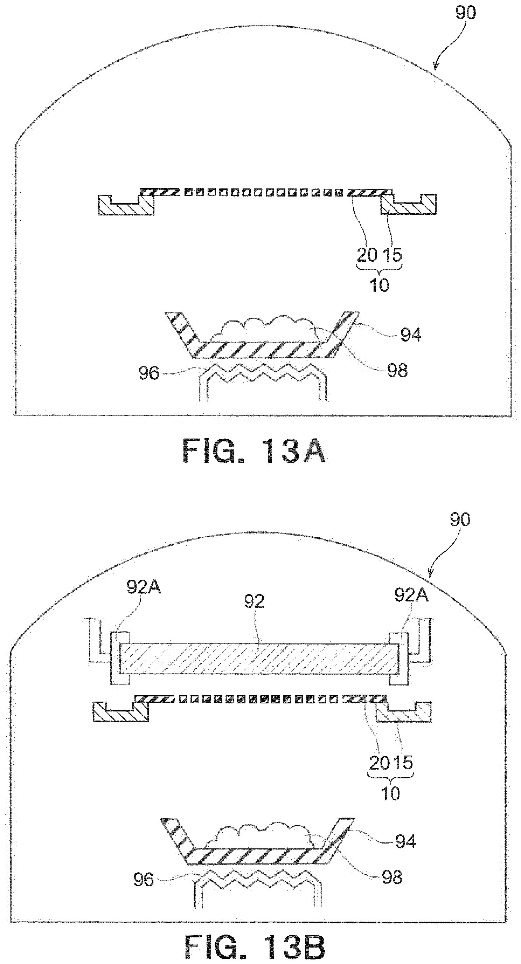

Next, a deposition method of a deposition material in which the deposition material 98 is deposited onto the organic EL substrate 92 with the use of the deposition mask apparatus obtained by the aforementioned steps is described with reference mainly to Figs. 13A to 14B.

Firstly, the deposition mask apparatus 10 obtained by the aforementioned steps is prepared. Namely, as shown in Fig. 13A, the deposition apparatus, which comprises the deposition mask apparatus 10, the crucible 94 containing the deposition material 98, and the heater 96, is prepared.

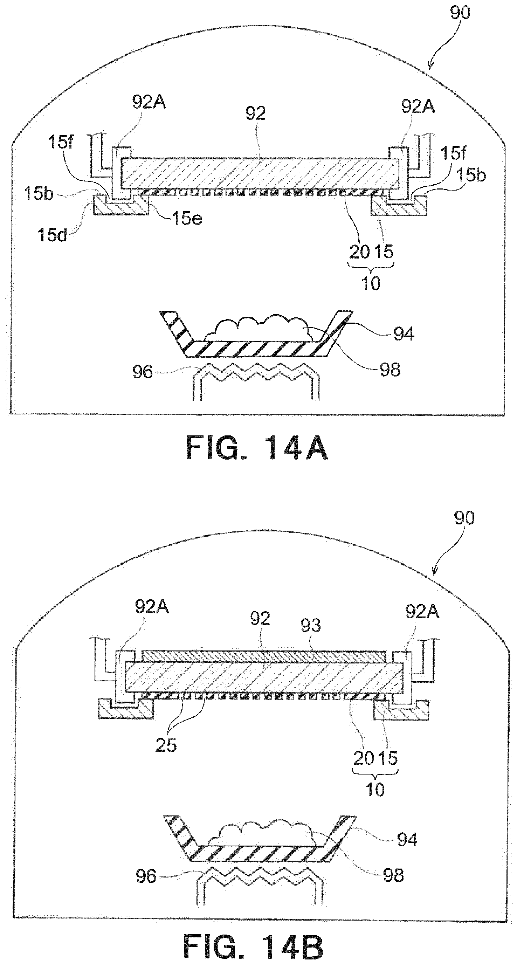

Then, as shown in Fig. 13B, while the organic EL substrate 92 is held by the holding member 92A, the organic EL substrate 92 is positioned and placed on the frame 15. In this case, for example, by directly observing an alignment mark, not shown, of the organic EL substrate 92 and an alignment mark, not shown of the deposition mask 20, the organic the organic EL substrate 92 is positioned such that these alignment marks are overlapped with each other. Alternatively, by means of a not-shown control unit, center position coordinates of the alignment mark of the organic EL substrate 92 and center position coordinates of the alignment mark of the deposition mask 20 may be separately measured, and the organic EL substrate 92 is positioned such that these center position coordinates have a predetermined positional relationship. At this time, as shown in Fig. 14A, at least a part of the holding member 92A is accommodated in the accommodation part 15f of the frame 15. Thus, interference between the frame 15 and the holding member 92A can be prevented, whereby the organic EL substrate 92 is installed at a desired position with respect to the deposition mask apparatus 10.

In addition, the plurality of accommodation parts 15f capable of accommodating at least a part of the holding member 92A are discretely provided in the front surface 15b of the frame 15. Thus, parts of the frame 15, each of which has a thickness S1 and is free of the accommodation part 15f, can be distributed over all the area of the frame 15. Thus, lowering of strength of the frame 15, which is caused by providing the frame 15 with the accommodation parts 15f, can be prevented. As a result, it can be prevented that the frame 15 is deformed such as bent by a force applied from the deposition mask 20. Therefore, the deposition material 98 can be precisely deposited onto the organic EL substrate 92 with the use of the deposition mask 20 supported on the frame 15.

In addition, the plurality of accommodation parts 15f are formed between the outside surface 15d and the inside surface 15e. Thus, in the front surface 15b of the frame 15, an area having the thickness S1 can be ensured outside the accommodation parts 15f, whereby lowering of the strength of the frame 15 can be effectively prevented.

Then, the deposition material 98 is deposited onto the organic EL substrate 92 installed on the frame 15. At this time, as shown in Fig. 14B, a magnet 93 is disposed on a surface of the organic EL substrate 92, which is opposed to the deposition mask 20. By providing the magnet 93, the deposition mask 20 is attracted toward the magnet 93 by a magnetic force, so that the deposition mask 20 can be brought into tight contact with the organic EL substrate 92. Then, the heater 96 heats the crucible 94 to evaporate the deposition material 98. Then, the deposition material 98 evaporated from the crucible 94 to reach the deposition mask apparatus 10 adheres to the organic EL substrate 92 through the through-holes 25 of the deposition mask 20 (see Fig. 1A). At this time, the holding member 92A may be removed from the organic EL substrate 92.

In this manner, the deposition material 98 can be deposited onto the organic EL substrate 92 in a desired pattern corresponding to the positions of the through-holes 25 of the deposition mask 20.

According to this embodiment, the plurality of accommodation parts 15a capable of accommodating at least a part of the holding member 92A are formed at positions of the front surface 15b of the frame 15 apart from the opening 15a. Thus, when the organic EL substrate 92 is installed on the deposition mask apparatus 10, the holding member 92A can be prevented from interfering with the frame 15. In addition, since the accommodation parts 15f are formed at positions apart from the opening 15a, the joint portion 19 can be ensured, whereby the welding strength of the joint portion 19 of the deposition mask 20 can be increased. Further, the plurality of accommodation parts 15f are formed in the front surface 15f of the frame 15. Namely, an area having the thickness S1 can be ensured between the plurality of accommodation parts 15f, and parts of the frame 15, each of which has a thickness S1 and is free of the accommodation part 15f, can be distributed over all the area of the frame 15. Thus, lowering of strength of the frame 15, which is caused by providing the frame 15 with the accommodation parts 15f, can be prevented. As a result, it can be prevented that the frame 15 is deformed such as bent by a force applied from the deposition mask 20. Therefore, the deposition material 98 can be precisely deposited onto the organic EL substrate 92 with the use of the deposition mask 20 supported on the frame 15.

In addition, according to this embodiment, the plurality of accommodation parts 15f are formed between the opening 15a and the outside surface 15d. Thus, in the front surface 15b of the frame 15, an area having the thickness S1 can be ensured outside the accommodation parts 15f, whereby lowering of the strength of the frame 15 can be effectively prevented.

The aforementioned embodiment can be variously modified. Hereinbelow, modification examples are described with reference to the drawings according to need. In the below description and the drawings used in the below description, a part that can be similarly constituted to the above embodiment has the same reference numeral as that of corresponding part the above embodiment, and overlapped description is omitted. In addition, when the effect obtained by the aforementioned embodiment is apparently obtained in the modification examples, description thereof is possibly omitted.

### (Modification Example of Manufacturing Method of Deposition Mask)

In the aforementioned embodiment and the modification example, the example in which the deposition mask 20 is manufactured by etching is described. However, a method employed for manufacturing the deposition mask 20 is not limited to etching. For example, as disclosed in the aforementioned Patent Document 2, the deposition mask 20 can be manufactured by forming the through-holes 25 in a metal plate by a plating process.

### (Modification Example of Ear Portion)

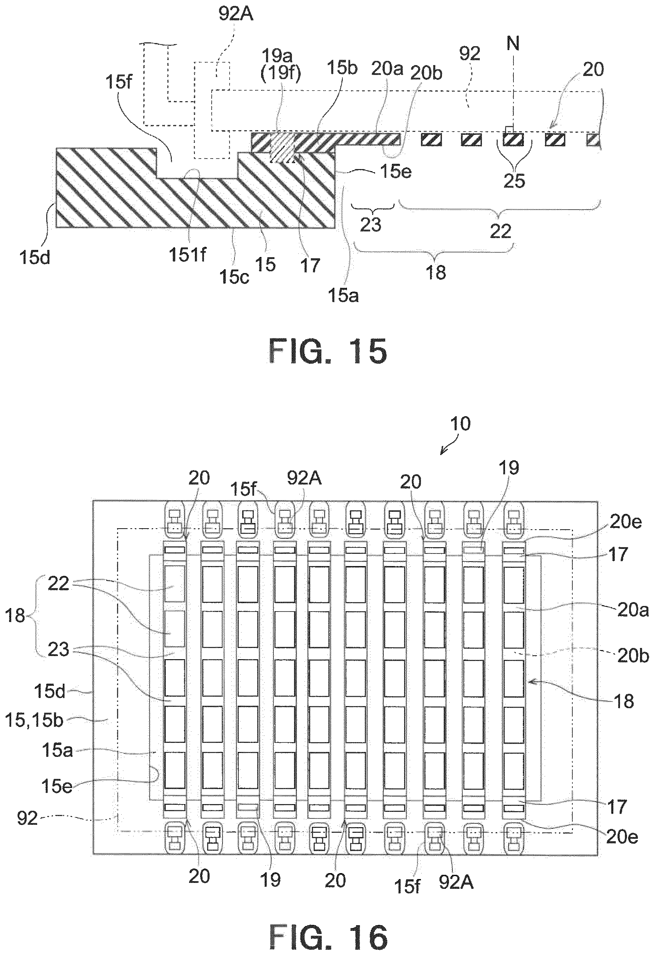

In the aforementioned embodiment and the modification example, the thickness of the ear portion 17 of the deposition mask 20 and the thickness of the intermediate portion 18 are the same with each other. However, not limited thereto, the thickness of the ear portion 17 and the thickness of the intermediate portion 18 may differ from each other. For example, as shown in Fig. 15, the thickness of the ear portion 17 may be greater than the thickness of the intermediate portion 18. In addition, although not shown, the thickness of the ear portion 17may be smaller than the thickness of the intermediate portion 18, for example.

### (First Modification Example of Frame)

In the aforementioned embodiment, the example in which the plurality of accommodation parts 15f of the frame 15 are formed between the opening 15a and the outside surface 15d is described. However, not limited thereto, as shown in Fig. 16, the plurality of accommodation parts 15f may extend to reach the outside surface 15d. Also in this case, since the plurality of accommodation parts 15f are provided to be spaced apart from each other, lowering of the strength of the frame 15 can be prevented.

### (Second Modification Example of Frame)

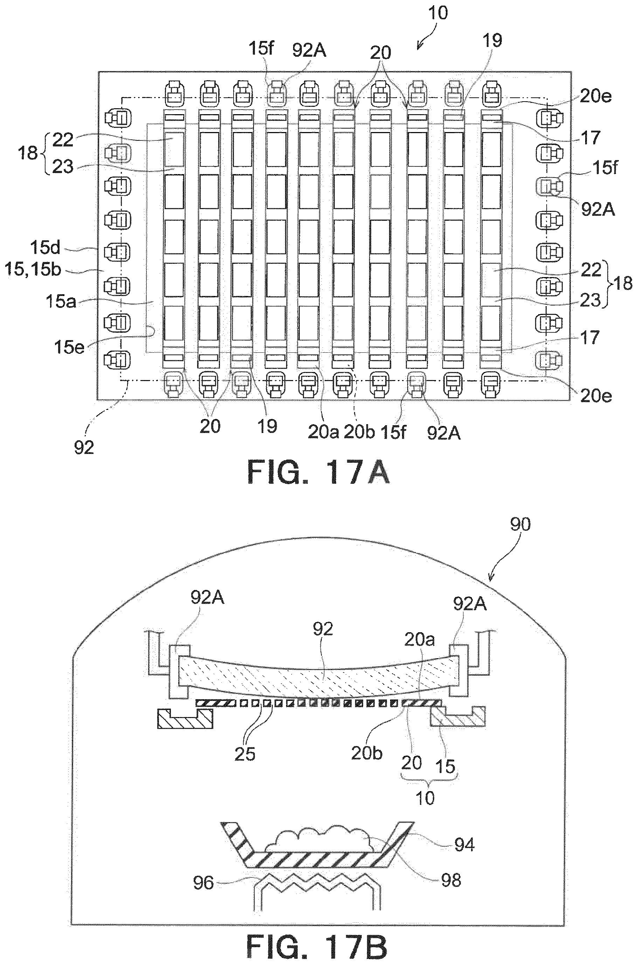

In the aforementioned embodiment and the modification example, the example in which the plurality of accommodation parts 15f of the frame 15 are formed between the opening 15a and the outside surface 15d is described. However, not limited thereto, as shown in Fig. 17A, the plurality of accommodation parts 15f may be formed to surround the opening 15a. Namely, the opening 15a may have a rectangular shape having four sides, and the plurality of accommodation parts 15f may be arranged side by side along the four sides of the opening 15a. In addition, in this case, in the aforementioned step of installing the organic EL substrate 92 on the frame 15, the holding member 92A may hold the four sides of the organic EL substrate 92.

In the step of installing the organic EL substrate 92 on the frame 15, there is a possibility that air enters between the organic EL substrate 92 and the deposition mask 20, resulting in bending of the organic EL substrate 92. In this case, it is difficult to deposit the deposition material 98 onto desired positions of the organic EL substrate 92.

On the other hand, according to this embodiment, since the plurality of accommodation parts 15f are formed to surround the opening 15a, in the step of installing the organic EL substrate 92 on the frame 15, the holding member 92A holds the four sides of the organic EL substrate 92. Thus, entering of air between the organic EL substrate 92 and the deposition mask 20 can be prevented. Namely, as shown in Fig. 17B, since the holding member 92A holds the four sides of the organic EL substrate 92, the organic EL substrate 92 bends by this own weight such that a part near the center of the organic EL substrate 92 is positioned most downward. In this case, when the organic EL substrate 92 comes into contact with the deposition mask 20, the organic EL substrate 92 can be brought into contact with the deposition mask 20 such that the organic EL substrate 92 and the deposition mask 20 are in point contact with each other. By gradually lowering the organic EL substrate 92 while the holding member 92A holds the four sides of the organic EL substrate 92, entering of air between the organic EL substrate 92 and the deposition mask 20 can be prevented. In addition, in the step of installing the organic EL substrate 92 on the frame 15, bending of the organic EL substrate 92 can be reduced, so that the organic EL substrate 92 can be stably transported. At the same time, risk of damage of the organic EL substrate 92 can be reduced. In particular, even when the organic EL substrate 92 is of a large size (e.g., G5.5Q size, or G6H size) or the organic EL substrate 92 has only a thickness of not more than 0.5 mm, the organic EL substrate 92 can be stably transported, and the risk of damage of the organic EL substrate 92 can be reduced.

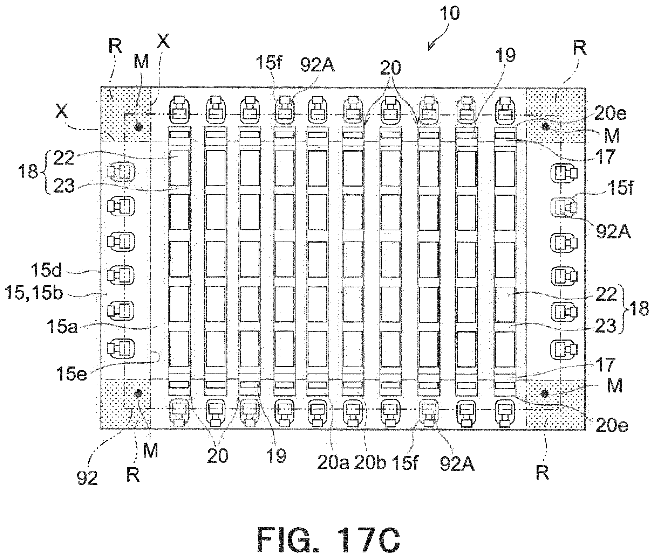

In addition, in this case, as shown in Fig. 17C, no accommodation part 15f may be provided in four corners of the frame 15. The four corners of the frame 15 mean areas surrounded by virtual lines X obtained by extending the four sides of the opening 15a to reach the outside surface 15d of the frame 15 and the outside surface 15d in plan view (satin-like areas in Fig. 17C). The frame 15 is provided with an alignment mark M for positioning the deposition mask 20 when the deposition mask 20 is joined to the frame 15. The alignment mark M is provided at a position that is not overlapped with the deposition mask 20 in plan view, after the deposition mask 20 has been joined to the frame 15. In addition, when the deposition mask 20 is positioned, it is desired that all the effective areas 22 of the deposition mask 20 are disposed at predetermined positions. In order to facilitate the positioning of all the effective areas 22, the alignment marks M are preferably provided on four corners of the frame 15. Thus, as in this modification example, since no accommodation parts 15f is provided in four corners of the frame 15, the alignment marks M can be reliably formed on four corners of the frame 15, whereby the deposition mask 20 can be easily positioned.

### (Third Modification Example of Frame)

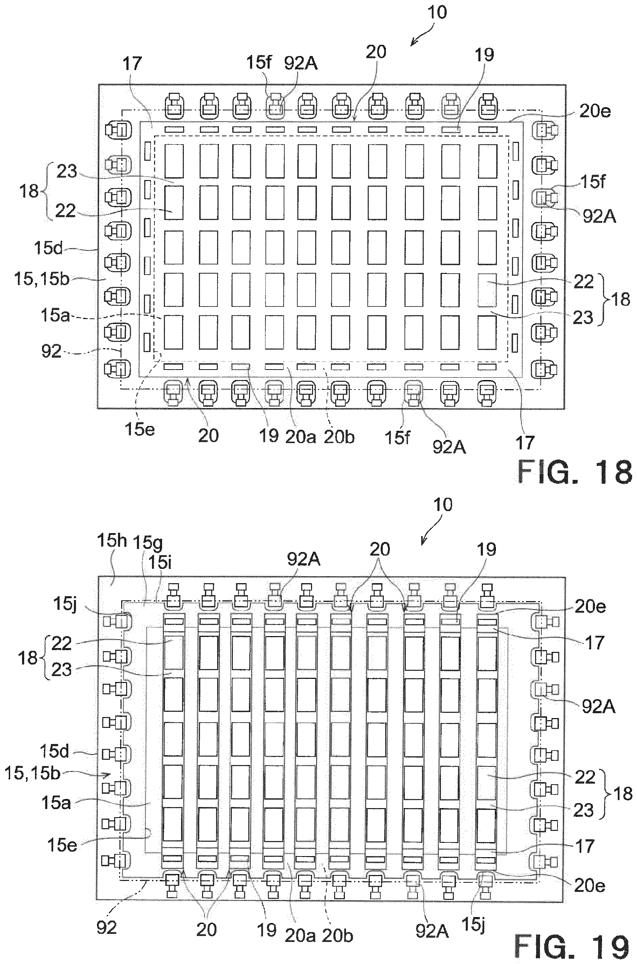

In the aforementioned embodiment and the modification examples, the example in which the deposition mask apparatus 10 uses the plurality of deposition masks 20 that are allocated to the frame 15 is described. However, not limited thereto, as shown in Fig. 18, the deposition mask apparatus 10 may use a single deposition mask 20 having a plurality of effective areas 22 that are arranged like a grid.

### (Fourth Modification Example of Frame)

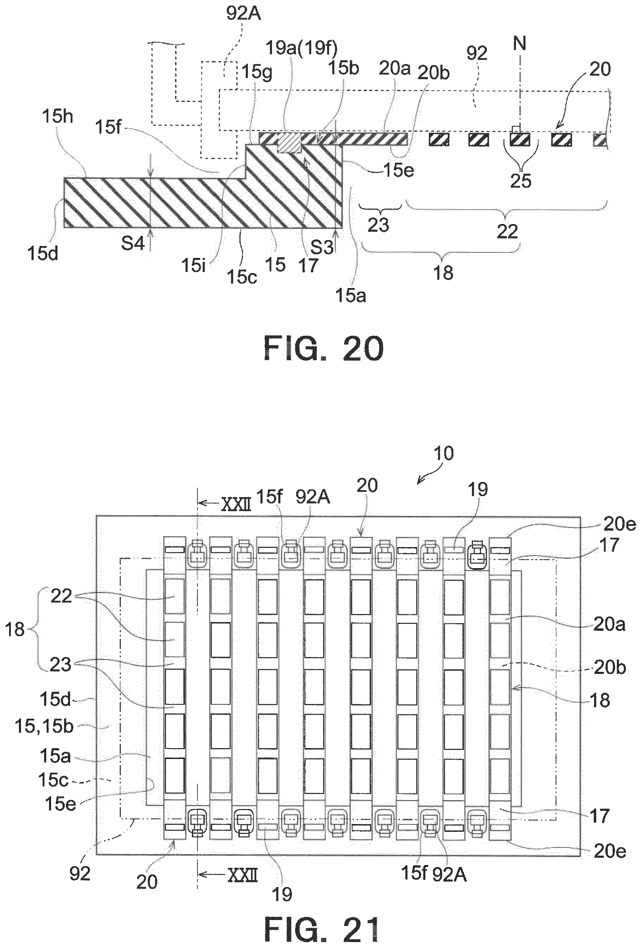

In the aforementioned embodiment and the modification examples, the example in which parts of the frame 15, each of which has the thickness S1, are distributed over all the area of the frame 15 is described. However, not limited thereto, as shown in Figs. 19 and 20, the front surface 15b of the frame 15 may include a first front surface 15g positioned closer to the inside surface 15e and a second front surface (i.e., fifth surface) 15h positioned closer to the outside surface 15d and positioned closer to the rear surface 15c than the first front surface 15g, the first front surface 15g and the second front surface 15h may be connected to each other through an intermediate surface 15i, and the accommodation parts 15f may be formed in the first front surface 15g that extend to reach the intermediate surface 15i.

In this case, in the frame 15, a thickness from the second front surface 15h to the rear surface 15c is uniformly small as compared with a thickness from the first front surface 15g to the rear surface 15c. In Fig. 20, the reference numeral S3 depicts a thickness from the second front surface 15g to the rear surface 15c, and the reference numeral S4 depicts a thickness from the first front surface 15h to the rear surface 15c. The thickness S4is determined depending on the size of the holding member 92A such that the holding member 92A can be prevented from interfering with the frame 15. For example, the thickness S4 may be not less than 2 mm, not less than 5 mm, not les than 7 mm, or not less than 10 mm. In addition, the thickness S4 may be not more than 20 mm, not more than 18 mm, not more than 15 mm, or not more than 12 mm. A range of the thickness S4 may be determined by combining any one of the above upper limit candidate values and any one of the above lower limit candidate values. For example, the range of the thickness S4 may be not less than 2 mm and not more than 20 mm, not less than 5 mm and not more than 18 mm, not less than 7 mm and not more than 15 mm, or not less than 10 mm and not more than 12 mm. In addition, the range of the thickness S4 may be determined by combining any two of the above upper limit candidate values. For example, the range of the thickness S4 may be not less than 15 mm and not more than 18 mm. In addition, the range of the thickness S4 may be determined by combining any two of the above lower limit candidate values. For example, the range of the thickness S4 may be not less than 7 mm and not more than 10 mm.

The thickness S3 from the first front surface 15g to the rear surface 15c is determined to prevent the frame 15 from deforming such as bending. For example, the thickness S3 may be not less than 5 mm, not less than 10 mm, not less than 15 mm or not less than 20 mm. In addition, the thickness S3 may be not more than 35 mm, not more than 30 mm, not more than 25 mm, or not more than 20 mm. A range of the thickness S3 may be determined by combining any one of the above upper limit candidate values and any one of the above lower limit candidate values. For example, the range of the thickness S3 may be not less than 5 mm and not more than 35 mm, not less than 10 mm and not more than 30 mm, or not less than 15 mm and not more than 25 mm. In addition, the range of the thickness S3 may be determined by combining any two of the above upper limit candidate values. For example, the range of the thickness S3 may be not less than 20 mm and not more than 30 mm. In addition, the range of the thickness S3 may be determined by combining any two of the above lower limit candidate values. For example, the range of the thickness S3 may be not less than 10 mm and not more than 15 mm. In addition, the thickness S3 may be determined depending on the thickness S4 from the second front surface 15h to the rear surface 15c. For example, the thickness S4 may be not less than 1.5 × S4 and not more than 3.0 × S4.

Preferably, the ratio (accommodation part ratio) of a planar dimension of a part of the first front surface 15g of the frame 15, in which the plurality of accommodation parts 15f are provided, is determined so as to prevent the frame 15 from deforming such as bending. For example, the accommodation part ratio may be not less than 5%, not less than 7%, or not less than 9%. In addition, the accommodation part ratio may be not more than 15%, not more than 13%, not more than 9%, or not more than 11%. A range of the accommodation part ratio may be determined by combining any one of the above upper limit candidate values and any one of the above lower limit candidate values. For example, the range of the accommodation part ratio may be not less than 5% and not more than 15%, not less than 7% and not more than 13%, or not less than 9% and not more than 11%. In addition, the range of the accommodation part ratio may be determined by combining any two of the above upper limit candidate values. For example, the range of the accommodation part ratio may be not less than 11% and not more than 15%. In addition, the rang of the accommodation part ratio may be determined by combining any two of the above lower limit candidate values. For example, the range of the accommodation part ratio may be not less than 5% and not more than 9%.

Also in this case, by installing the organic EL substrate 92 on the deposition mask apparatus 10 such that the accommodation parts 15f accommodate at least a part of the holding member 92A or that the holding member 92A is positioned on the second front surface 15h of the frame 15, it can be prevented that the holding member 92A from interfering with the frame 15.

### (Fifth Modification Example of Frame)

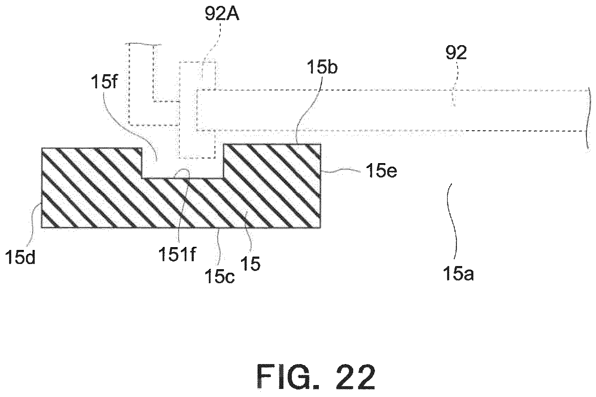

In the aforementioned embodiment and the modification examples, the example in which the plurality of accommodation parts 15f are formed outside the pair of ends 20e of the deposition mask 20 is described. However, not limited thereto, as shown in Figs. 21 and 22, the plurality of accommodation parts 15f may be formed inside the pair of ends 20e of the deposition mask 20. In this case, all of the respective accommodation parts 15f may be formed inside the pair of ends 20e of the deposition mask 20, or only some of the respective accommodation parts 15f may be formed inside the pair of ends 20e of the deposition mask 20. In addition, in this case, the plurality of accommodation parts 15f are discretely provided in the front surface 15b of the frame 15 so as to be positioned between the plurality of deposition masks 20. In addition, in this case, the organic EL substrate 92 may not extend outside a part of the deposition mask 20, at which the joint portion 19 is formed, but may be positioned inside the part at which the joint portion 19 is formed.

As described above, after the deposition mask 20 has been welded to the frame 15, a part of the ear portion 17 is removed. Thus, in the pair of ends 20e of the deposition mask 20, there is a possibility that burr occurs by cutting. When burr occurs in the pair of ends 20e, adhesion between the deposition mask 20 and the organic EL substrate 92 is lowered by the burr, which may result in defective deposition. On the other hand, according to this modification example, the plurality of accommodation parts 15f are discretely provided in the front surface 15b of the frame 15, such that the plurality of accommodation parts 15f are formed inside the pair of ends 20e of the deposition mask 20 and are positioned between the plurality of deposition masks 20. Therefore, the organic EL substrate 92 can be positioned inside the part of the deposition mask 20, at which the joint portion 19 is formed, so that it can be prevented that the organic EL substrate 92 overlaps with the pair of ends 20e of the deposition mask 20. Thus, even when burr occurs in the pair of ends 20e of the deposition mask 20, lowering of adhesion between the deposition mask 20 and the organic EL substrate 92 by the burr can be prevented, whereby defective deposition can be avoided.

### (Sixth Modification Example of Frame)

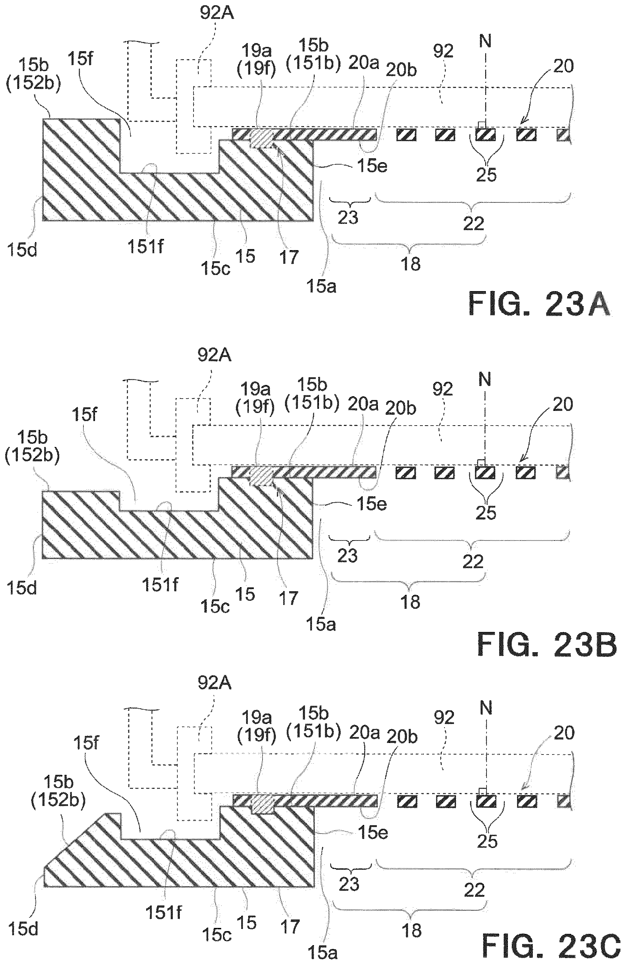

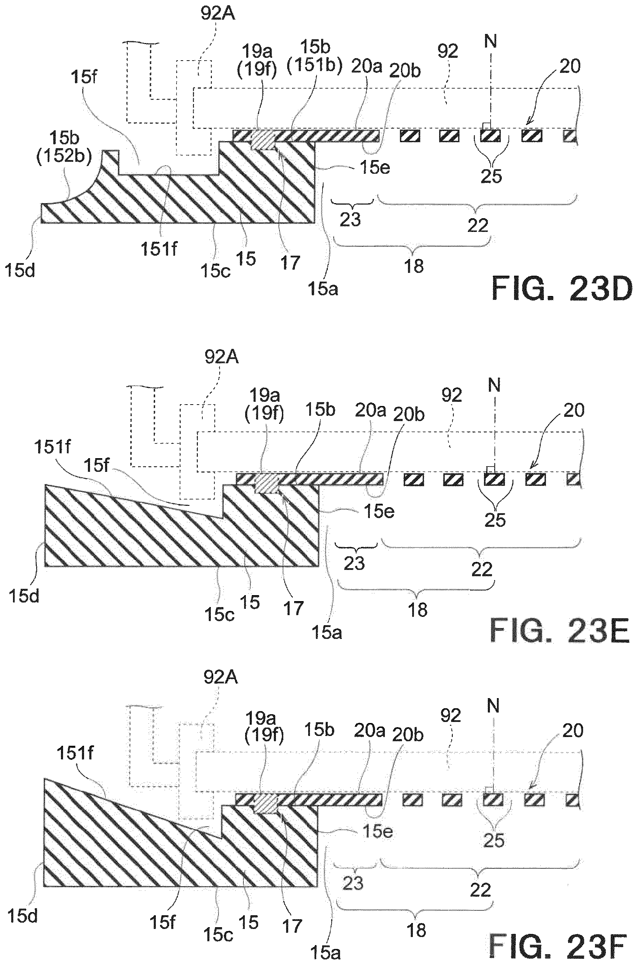

In the aforementioned embodiment and the modification examples, the example in which the the front surface 151b of the front surface 15b of the frame 15, which is positioned inside the accommodation part 15f, and the front surface 152b thereof, which is positioned outside the accommodation part 15f, are positioned on the same surface, when seen along the normal direction N of the first surface 20a. However, the present invention is not limited thereto. As described below, the frame 15 may have various shapes. For example, as shown in Fig. 23A, the front surface 152b of the front surface 15b of the frame 15, which is positioned outside the accommodation part 15f, may be positioned closer to the deposition mask 20 than the front surface 151b thereof, which is positioned inside the accommodation part 15f. In this case, a thickness of a part of the frame 15, which is positioned outside the accommodation part 15f, can be increased, so that the strength of the frame 15 can be increased. In addition, as shown in Fig. 23B, the front surface 151b of the front surface 15b of the frame 15, which is positioned inside the accommodation part 15f, may be positioned closer to the deposition mask 20 than the front surface 152b thereof, which is positioned outside the accommodation part 15f. Also in this case, it can be prevented that the holding member 92A from interfering with the frame 15. In addition, as shown in Fig. 23C, a part of the front surface 152b of the front surface 15b of the frame 15, which is positioned outside the accommodation part 15f, may be inclined toward the rear surface 15c of the frame 15 as it goes outward, when seen along the normal direction N of the first surface 20a. In addition, in this case, as shown in Fig. 23D, a part of the front surface 152b of the front surface 15b of the frame 15, which positioned outside the accommodation part 15f may have a curvilinear shape, when seen along the normal direction of the first surface 20a. Also in this case, it can be prevented that the holding member 92A from interfering with the frame 15.

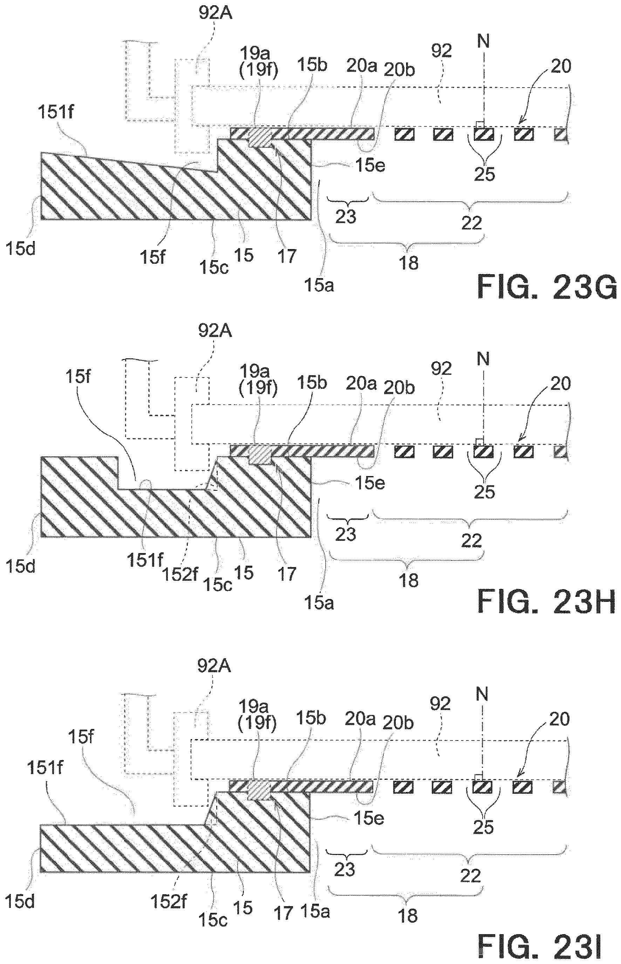

In addition, as shown in Figs. 23E to 23G, the accommodation part 15f may extend to reach the outside surface 15d, and the surface 151f of the accommodation part 15f may be inclined toward the deposition mask 20 as it goes outward. In this case, as shown in Fig. 23E, when seen along the normal direction N of the first surface 20a, an end of the accommodation part 15f may be positioned on the same plane as the front surface 151b of the front surface 15b of the frame 15, which positioned inside the accommodation part 15f. In addition, as shown in Fig. 23F, the end of the accommodation part 15f may be positioned closer to the deposition mask 20 than the front surface 151b of the front surface 15b of the frame 15, which positioned inside the accommodation part 15f. In this case, a part of the surface 151f (i.e., fifth surface) of the accommodation part 15f may be positioned closer to the deposition mask 20 than the front surface 151b of the front surface 15b of the frame 15, which positioned inside the accommodation part 15f. In addition, as shown in Fig. 23G, a part of the surface 151f (i.e., fifth surface) of the accommodation part 15f may be positioned closer to the rear surface 15c of the frame 15 than the front surface 151b. Also in this case, it can be prevented that the holding member 92A from interfering with the frame 15.

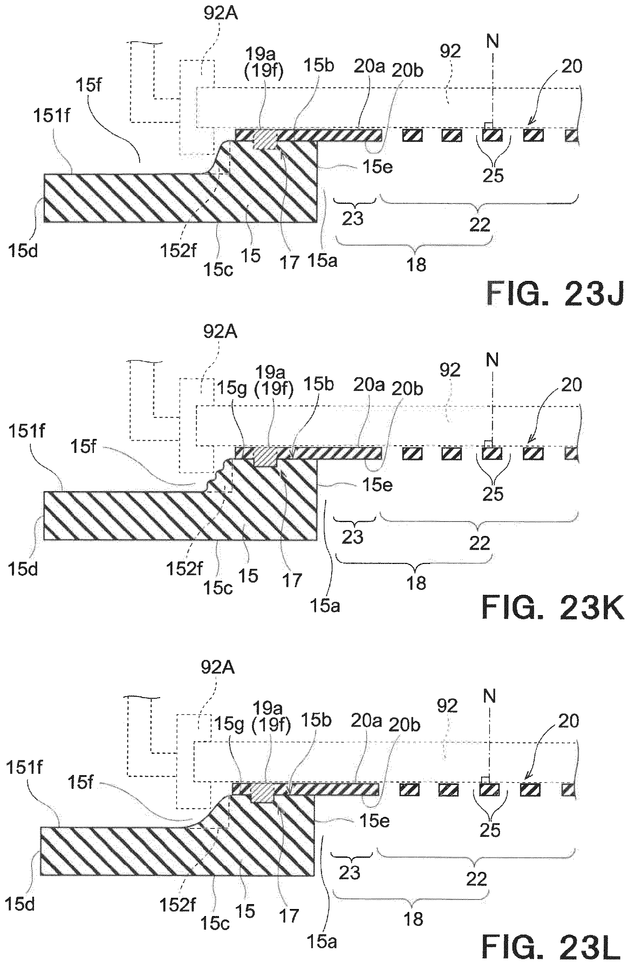

In addition, as shown in Fig. 23H, the accommodation part 15f may include an inclined portion (see dotted lines in Fig. 23H) 152f which is inclined toward the deposition mask 20 as it goes inward. In this case, at the accommodation part 15f of the frame 15, the thickness of the frame 15 can be increased, whereby the strength of the frame 15 an be increased. In addition, also in this case, as shown in Fig. 23I, the plurality of accommodation parts 15f may extend to reach the outside surface 15d. Also in this case, at the accommodation part 15f of the frame 15, the thickness of the frame 15 can be increased, whereby the strength of the frame 15 an be increased. In addition, as shown in Fig. 23J, when seen along the normal direction N of the first surface 20a, the inclined portion 152f may be formed to smoothly connect to the front surface 15b of the frame 15 and the surface 151f of the accommodation part 15f. In addition, as shown in Fig. 23K, when seen along the normal direction N of the first surface 20a ,the inclined portion 152f may have a wavelike form. Further, as shown in Fig. 23L, when seen along the normal direction N of the first surface 20a, the inclined portion 152f may have a curvilinear shape.

### (Seventh Modification Example of Frame)

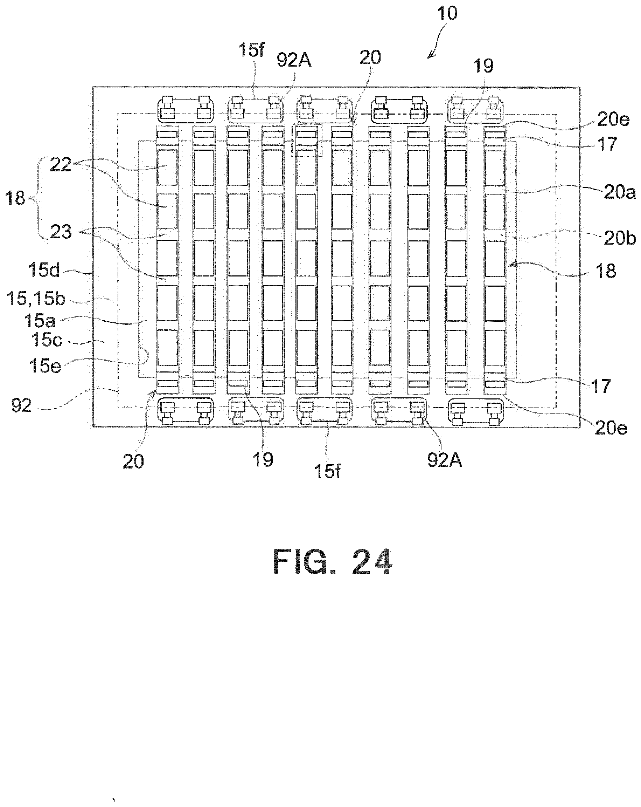

In addition, as shown in Fig. 24, a plurality of the holding members 92A may be accommodated in one accommodation part 15f. In the illustrated example, two holding members 92A are accommodated in one accommodation part 15f. The number of the holding members 92A to be accommodated in one accommodation part 15f may be three or more. When the plurality of holding members 92A are accommodated in one accommodation part 15f, a planar dimension of each accommodation part 15f in plan view can be increased, and the number of the accommodation parts 15f can be decreased. Thus, a step of manufacturing the frame 15 can be facilitated.

### (Modification Example of Holding Member)

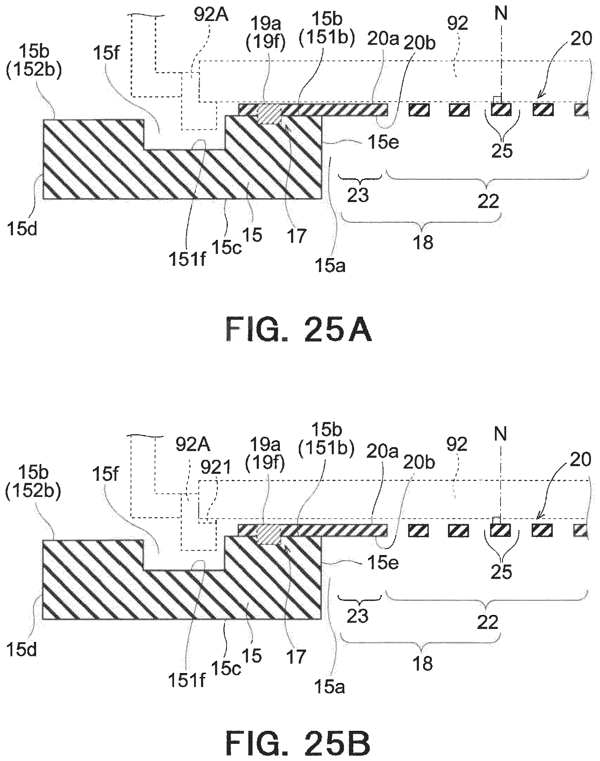

In the aforementioned embodiment and the modification examples, the example in which the holding member 92A is a clamp that clamps the organic EL substrate 92 is described. However, the present invention is not limited thereto. For example, as shown in Fig. 25A, the holding member 92A may be configured to support one of surfaces of the organic EL substrate 92, which is on the side of the deposition mask 20, without clamping the organic EL substrate 92. Also in this case, the holding member 92A can hold the organic EL substrate 92. In this case, as shown in Fig. 25B, the holding member 92A may include an adhesive member 921 for adhering the organic EL substrate 92 to the holding member 92A. In this case, since the organic EL substrate 92 can be adhered to the holding member 92A, the holding member 92A can effectively hold the organic EL substrate 92.

## Claims

1. A deposition mask apparatus to be at least temporarily combined with a substrate held by a holding member, the deposition mask apparatus comprising:
a deposition mask having a plurality of mask through-holes extending from a first surface which is positioned closer to the substrate, to reach a second surface which is positioned opposite to the first surface; and
a frame provided with an opening which is overlapped with a part of the deposition mask, the frame supporting the deposition mask;
wherein:
the frame has a front surface facing the second surface of the deposition mask, a rear surface opposed to the front surface, an outside surface spreading between the front surface and the rear surface, and an inside surface spreading inside the outside surface between the front surface and the rear surface to face the opening; and
a plurality of accommodation parts capable of accommodating at least a part of the holding member are formed in the front surface of the frame at positions apart from the opening.

2. The deposition mask apparatus according to claim 1, wherein
the plurality of accommodation parts are formed between the opening and the outside surface.

3. The deposition mask apparatus according to claim 1, wherein
the plurality of accommodation parts extend to reach the outside surface.

4. The deposition mask apparatus according to claim 1, wherein:
the front surface of the frame includes a first front surface positioned closer to the inside surface, and a second front surface positioned closer to the outside surface and positioned closer to the rear surface than the first front surface ;
the first front surface and the second front surface are connected to each other through an intermediate surface; and
the accommodation parts are formed in the first front surface to extend to reach the intermediate surface.

5. The deposition mask apparatus according to any one of claims 1 to 4, wherein
the plurality of accommodation parts are formed to surround the opening.

6. The deposition mask apparatus according to any one of claims 1 to 5, wherein:
the deposition mask includes a joint portion welded to the front surface of the frame; and
at least a part of the joint portion is positioned between the opening and the accommodation parts.

7. The deposition mask apparatus according to any one of claims 1 to 5, wherein:
at least some of the respective accommodation parts are formed inside a pair of ends in a longitudinal direction of the deposition mask.

8. A deposition mask apparatus comprising:
a deposition mask having a first surface, and a second surface positioned opposite to the first surface; and
a frame having a third surface positioned closer to the deposition mask, and a fourth surface positioned opposite to the third surface;
wherein:
the deposition mask and the frame are joined to each other through a joint portion;
the frame further has a fifth surface positioned outside the joint portion; and
at least a part of the fifth surface is positioned closer to the fourth surface than the third surface.
